# EUROPEAN PATENT APPLICATION

(11) **EP 4 654 392 A1**
(43) Date of publication of application: **26.11.2025**
(21) Application number: 24764106.1
(22) Date of filing: 06.02.2024
(51) Int. Cl.: H01R 12/71, H01R 13/04, H01R 13/10, H01R 12/77, G09F 9/30, H04M 1/02

(54) **ELECTRONIC DEVICE INCLUDING TERMINAL STRUCTURE**

(30) Priority: 27.02.2023 KR 20230025617; 23.03.2023 KR 20230037993
(71) Applicant: Samsung Electronics Co., Ltd., Suwon-si, Gyeonggi-do 16677 (KR)
(72) Inventor: RHEE, Minsu, Suwon-si, Gyeonggi-do 16677 (KR); LIM, Gun, Suwon-si, Gyeonggi-do 16677 (KR)
(74) Representative: Gulde & Partner
(86) International application number: PCT/KR2024/001710
(87) International publication number: WO 2024/181706

(57) **Abstract**

An electronic device according to an embodiment of the present disclosure includes a printed circuit board, a housing in which the printed circuit board is disposed, and a terminal structure of which at least a portion is disposed in the housing, wherein the terminal structure includes: a connector portion including a first connector having a connector terminal disposed therein and a second connector electrically connected to the printed circuit board; a deco portion that is disposed on the first connector and includes a conductive region exposed to the outside of the housing and a non-conductive region surrounding the conductive region; and a cover portion disposed between the deco portion and the housing and including a cover opening in which at least a portion of the conductive region is disposed.

## Description

### [Technical Field]

The disclosure relates to an electronic device including a terminal structure.

### [Background Art]

An electronic device may include a pogo pad for purposes such as communication and charging thereof. The pogo pad may be a connection terminal having a circular cross-section and made of a conductive metal.

An electronic device may include a plurality of pogo pads. The multiple pogo pads may have different uses. For example, one pogo pad may be used for data transmission, and another pogo pad may be used for identification of an external device.

The pogo pads may be disposed on at least one of the external surfaces of the electronic device. For example, a plurality of pogo pads may be arranged at regular intervals from each other on the side surface of the electronic device.

### [Disclosure of Invention]

### [Technical Problem]

As the use of pogo pads increases, the number of pogo pads arranged on the electronic device may also increase. The increase in the number of pogo pads may cause degradation of the aesthetics of the electronic device.

### [Solution to Problem]

An electronic device according to an embodiment of the disclosure may include a printed circuit board, a housing, and a terminal structure.

In an embodiment, the printed circuit board may be disposed inside the housing.

In an embodiment, the terminal structure may be disposed at least partially in a region of the housing.

The terminal structure according to an embodiment of the disclosure may include a connector part, a decoration part, and a cover part.

In an embodiment, **the connector part** may include a first connector in which a connector terminal is disposed, and a second connector electrically connected to the printed circuit board.

In one embodiment, the decoration part may include a conductive region that contacts the connector terminal at one end and is exposed to the exterior of the housing at the other end, and a non-conductive region surrounding the conductive region, and may be disposed on the first connector.

In an embodiment, the cover part may include a cover opening in which at least a portion of the conductive area is disposed, and may be disposed between the decoration part and the housing.

### [Advantageous Effects of Invention]

The electronic device according to an embodiment of the disclosure may improve the aesthetics thereof by arranging a terminal (e.g., pogo pad) in a region (logo region) of the housing.

The electronic device according to an embodiment of the disclosure may include at least one terminal (e.g., pogo pad) having a specified function in a region (e.g., logo region) of the housing.

### [Brief Description of Drawings]

FIG. 1 is a block diagram of an electronic device in a network environment according to an embodiment.
FIGS. 2A and 2B are views illustrating an electronic device according to an embodiment of the disclosure.
FIGS. 3A and 3B are views illustrating a terminal structure according to an embodiment of the disclosure.
FIGS. 4A and 4B are views illustrating a terminal structure according to an embodiment of the disclosure.
FIGS. 5A and 5B are views illustrating a cover part according to an embodiment of the disclosure.
FIGS. 6A, 6B, 6C and 6D are views illustrating a decoration part according to an embodiment of the disclosure.
FIG. 7 is a view illustrating an adhesive part according to an embodiment of the disclosure.
FIG. 8 is a view illustrating a connector part according to an embodiment of the disclosure.
FIG. 9 is a view illustrating a connector part including a second flexible printed circuit board connected to a second connector according to an embodiment of the disclosure.
FIG. 10 is a view illustrating a connector part including a second flexible circuit board connected to a first connector according to an embodiment of the disclosure.
FIGS. 11A, 11B and 11C are views illustrating a cover part, a decoration part, and a connector part according to an embodiment of the disclosure.
FIGS. 12A and 12B are views illustrating the decoration part according to an embodiment of the disclosure.
FIGS. 13A and 13B are views illustrating an electronic device according to an embodiment of the disclosure.
FIGS. 14A and 14B are diagrams illustrating an electronic device including a bracket according to an embodiment of the disclosure.
FIG. 15 is a diagram illustrating an electronic device including a contact pin according to an embodiment of the disclosure.
FIGS. 16A, 16B and 16C are views illustrating an electronic device according to an embodiment of the disclosure.
FIGS. 17A, 17B and 17C are views illustrating an electronic device according to an embodiment of the disclosure.

### [Mode for the Invention]

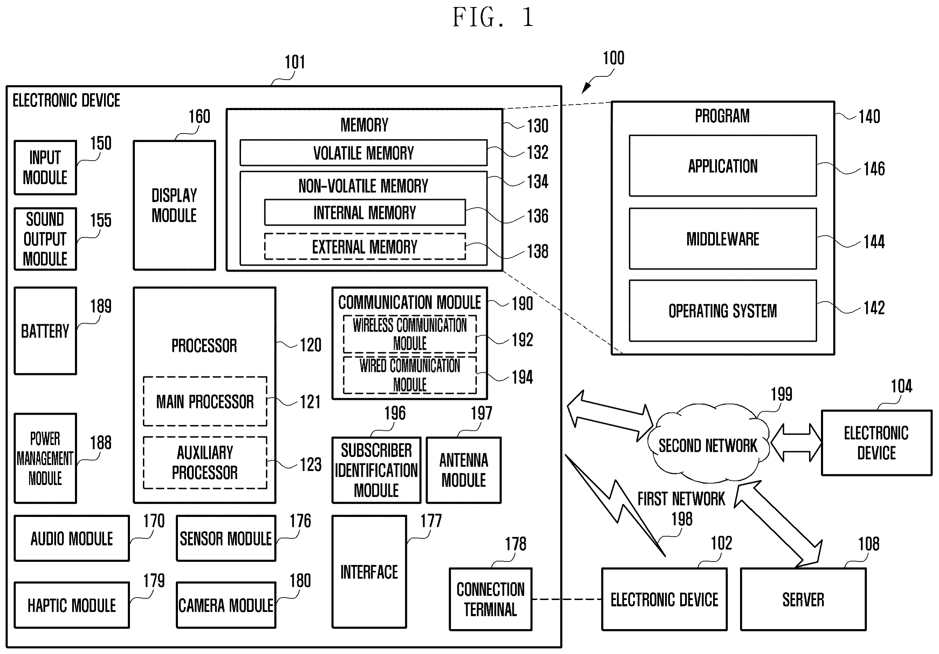

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

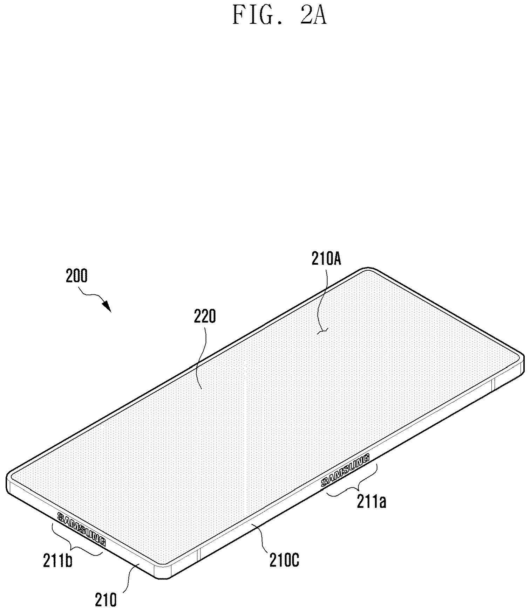

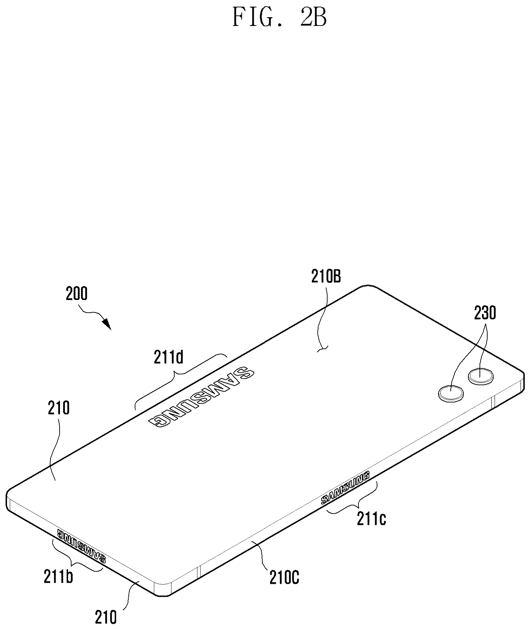

FIGS. 2A and 2B are views illustrating an electronic device 200 according to an embodiment of the disclosure.

The electronic device 200 according to an embodiment of the disclosure may include a housing 210, a display 220, and/or a camera 230.

In an embodiment, the housing 210 may include a front surface 210A, a rear surface 210B, and/or a side surface 210C. The front surface 210A of the housing 210 may be formed substantially parallel to the rear surface 210B of the housing 210. The side surface 210C of the housing 210 may indicate a surface surrounding the space formed between the front surface 210A and the rear surface 210B.

In an embodiment, the display 220 may be disposed on the front surface 210A of the housing 210. The camera 230 may be disposed on the rear surface 210B of the housing 210.

In an embodiment, the display 220 in FIG. 2A may refer to the display module 160 in FIG. 1, or may include at least a part of the display module 160. The display 220 may visually provide information to the outside of the electronic device 200.

In an embodiment, the camera 230 in FIG. 2A may refer to the camera module 180 in FIG. 1, or may include at least a part of the camera module 180. The camera 230 may capture still images and moving images.

In an embodiment, the housing 210 may include at least one housing opening 211a, 211b, 211c and 211d. For example, the housing 210 may include a first housing opening 211a, a second housing opening 211b, a third housing opening 211c, and/or a fourth housing opening 211d. The housing openings 211a, 211b, 211c and 211d may be formed in a region of the housing 210 (e.g., logo region).

In an embodiment, the housing openings 211a, 211b, 211c and 211d may be formed on a surface of the housing 210 where the display 220 is not disposed. For example, the first housing opening 211a, the second housing opening 211b, and the third housing opening 211c may be formed on the side surface 210C of the housing 210. The fourth housing opening 211d may be formed on the rear surface 210B of the housing 210.

In an embodiment, the housing openings 211a, 211b, 211c and 211d may be formed in the shape of a logo displayed on the electronic device 200. For example, the housing opening (e.g., 211a) may be in the shape of letters representing the logo.

With reference to FIGS. 2A and 2B, the housing opening (e.g., 211a) is illustrated as being formed in the shape of letters, but this is exemplary, and the shape of the housing opening (e.g., 211a) may be not limited thereto. For example, the housing opening (e.g., 211a) may be formed in the shape of letters, numbers, symbols, or a combination thereof.

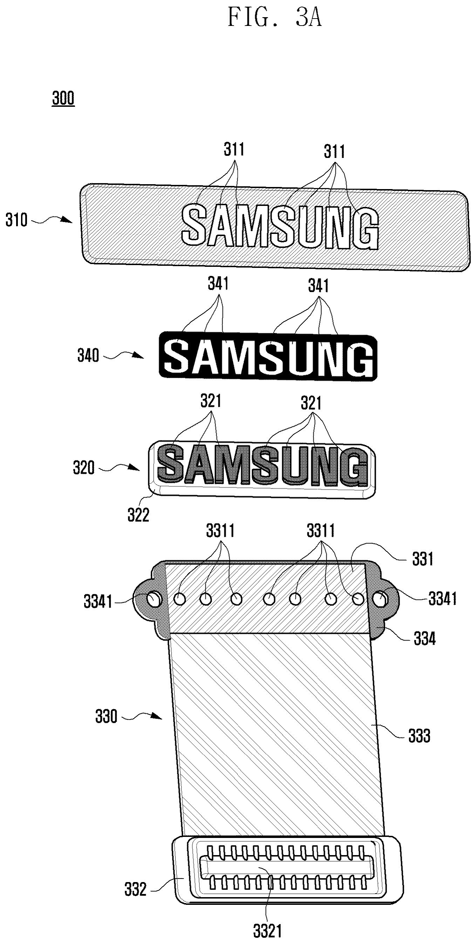

In an embodiment, the electronic device 200 may include a terminal structure 300 (refer to FIG. 3A). At least a portion of the terminal structure 300 (refer to FIG. 3A) may be exposed to the outside of the electronic device 200 through the housing openings 211a, 211b, 211c and 211d.

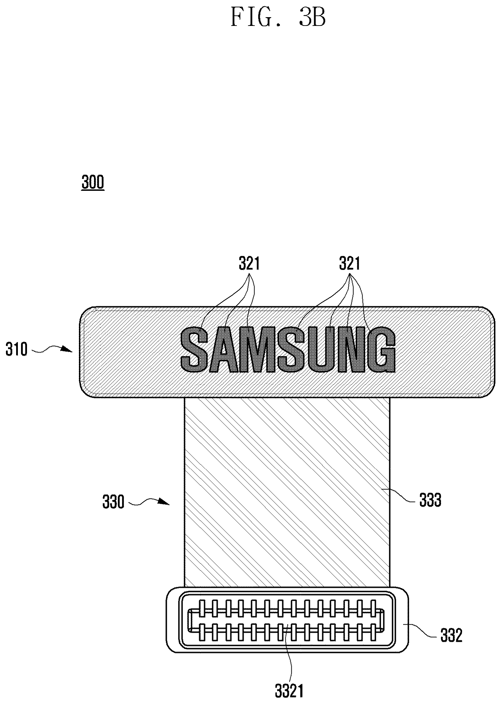

FIGS. 3A and 3B are views illustrating the terminal structure 300 according to an embodiment of the disclosure.

FIG. 3A is an exploded perspective view of the terminal structure 300 according to an embodiment. FIG. 3B is a view illustrating the terminal structure 300 according to an embodiment.

The terminal structure 300 according to an embodiment of the disclosure may include a cover part 310, a decoration part 320, a connector part 330, and/or an adhesive part 340.

In an embodiment, the connector part 330, the decoration part 320, and the cover part 310 may be stacked in that order. For example, the decoration part 320 may be disposed in one direction of the connector part 330, and the cover part 310 may be disposed in one direction of the decoration part 320.

In an embodiment, the adhesive part 340 may be disposed between the cover part 310 and the decoration part 320. For example, the cover part 310 may be disposed on one side of the adhesive part 340, and the decoration part 320 may be disposed on the other side of the adhesive part 340. The adhesive part 340 may be adhered to the cover part 310 on one side and to the decoration part 320 on the other side.

In an embodiment, the decoration part 320 may include a conductive region 321 and/or a non-conductive region 322. The conductive region 321 may be formed to extend to have a thickness on one side of the non-conductive region 322. The non-conductive region 322 may be disposed so as to surround at least a portion of the conductive region 321 at the periphery of the conductive region 321.

In an embodiment, the connector part 330 may include a first connector 331, a second connector 332, a flexible printed circuit board 333, and/or a support member 334.

In an embodiment, the first connector 331 may be disposed at one end of the flexible printed circuit board 333. The second connector 332 may be disposed at the other end of the flexible printed circuit board 333. The flexible printed circuit board 333 may be electrically connected to the first connector 331 at one end and electrically connected to the second connector 332 at the other end.

In an embodiment, the first connector 331 may include at least one connector terminal 3311. Each of the at least one connector terminal 3311 may be electrically connected by coming into contact with the conductive region 321 of the decoration part 320.

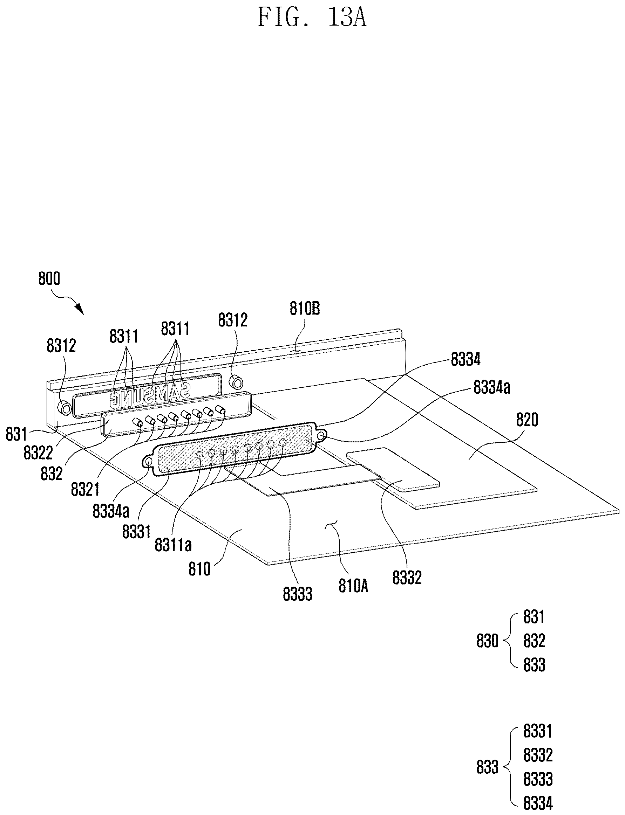

In an embodiment, the second connector 332 may include a first connector pin region 3321. The second connector 332 may be disposed on a printed circuit board 820 (refer to FIG. 13A) located outside the terminal structure 300. The second connector 332 may be electrically connected to the printed circuit board 820 (refer to FIG. 13A) in the first connector pin region 3321.

In an embodiment, the support member 334 may serve to support the first connector 331. The support member 334 may include support member openings 3341 at one end and the other end.

In an embodiment, the cover part 310 may include a cover opening 311. The cover opening 311 may be formed in a shape substantially identical to the perimeter of the conductive region 321.

In an embodiment, the cover part 310 may be formed to be in contact with the housing 210 (refer to FIG. 2A) inside the electronic device 200 (refer to FIG. 2A). The cover opening 311 may be formed in a position corresponding to the housing opening (e.g., 211a, refer to FIG. 2A) of the housing 210 in substantially the same shape.

In an embodiment, the cover part 310 may be included in the housing 210 (refer to FIG. 2A) of the electronic device 200 (refer to FIG. 2A) rather than being formed separately from the housing 210 (refer to FIG. 2A). When the cover part 310 is included in the housing 210, the cover opening 311 may indicate a housing opening (e.g., 211a, refer to FIG. 2A).

In an embodiment, at least a portion of the conductive region 321 may penetrate the cover opening 311 to be disposed on the cover part 310. For example, with reference to FIG. 3B, the conductive region 321 may be disposed on the cover part 310 by having a portion protruding toward the cover part 310 penetrate the cover opening 311.

In one embodiment, the adhesive part 340 may include an adhesive part opening 341. The adhesive part opening 341 may be formed in a shape substantially identical to the perimeter of the conductive region 321.

In an embodiment, when the cover part 310, the decoration part 320 and the adhesive part 340 are combined, at least a portion of the conductive region 321 of the decoration part 320 may penetrate the adhesive part opening 341 and be disposed in the cover opening 311.

With reference to FIGS. 3A and 3B, the cover opening 311, the conductive region 321, and the adhesive part opening 341 are illustrated as being formed in the shape of letters, but this is exemplary, and the shape of the cover opening 311, the conductive region 321, and the adhesive part opening 341 may be not limited thereto. For example, the cover opening 311, the conductive region 321, and the adhesive part opening 341 may be formed in the shape of letters, numbers, symbols, or a combination thereof.

In an embodiment, the conductive region 321 of the decoration part 320 may be exposed to the outside of the electronic device 200 (refer to FIG. 2A) through the cover opening 311 of the cover part 310. The conductive region 321 exposed to the outside of the electronic device 200 may be a pogo pad.

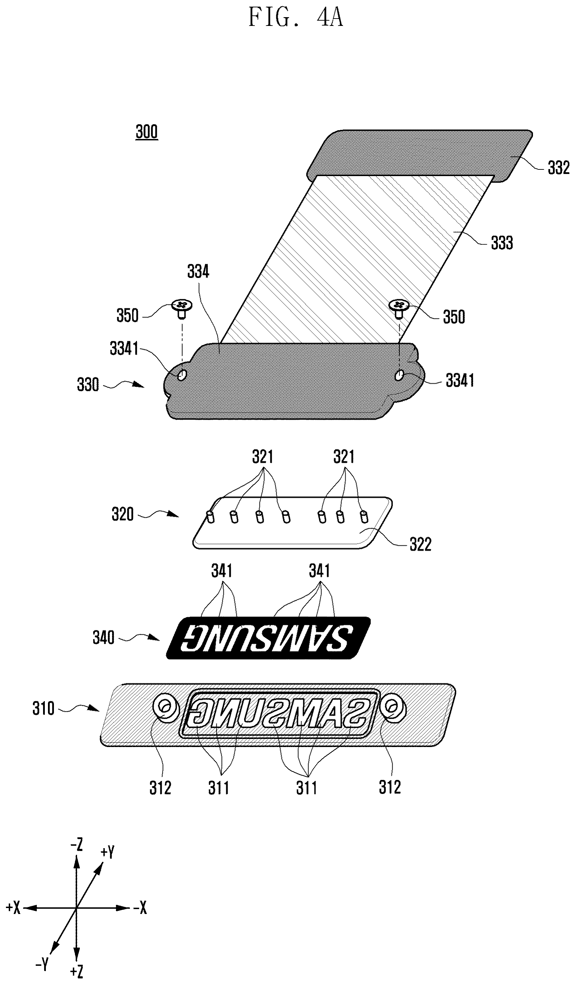

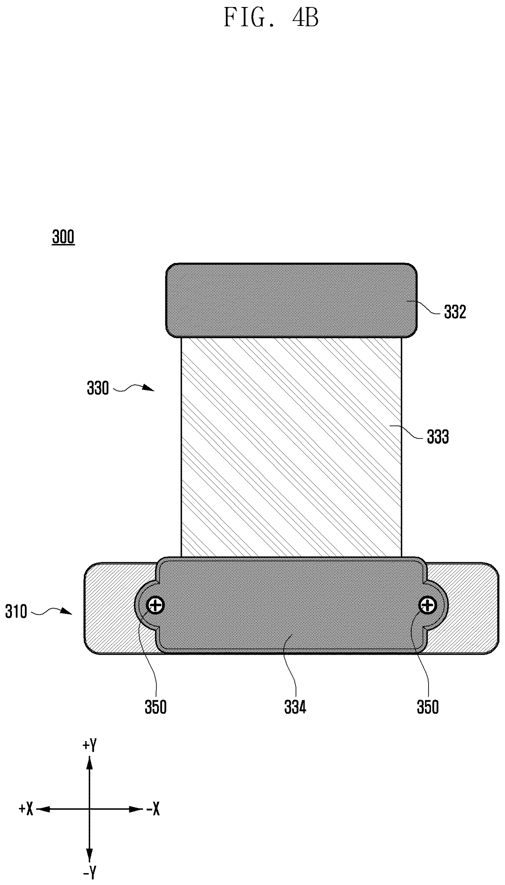

FIGS. 4A and 4B are views illustrating a terminal structure 300 according to an embodiment of the disclosure.

FIG. 4A is an exploded perspective view of the terminal structure 300 according to an embodiment. FIG. 4B is a view illustrating the terminal structure 300 according to an embodiment in the opposite direction of the terminal structure 300 shown in FIG. 3B.

The terminal structure 300 according to an embodiment of the disclosure may include a cover part 310, a decoration part 320, a connector part 330, an adhesive part 340, and/or a coupling member 350.

In describing the terminal structure 300 according to an embodiment of the disclosure, the width direction of the terminal structure 300 may indicate the x-axis direction, and the length direction of the terminal structure 300 may indicate the y-axis direction. The height direction of the terminal structure 300 may indicate the z-axis direction.

In an embodiment, the connector part 330, the decoration part 320, and the cover part 310 may be stacked in this order with respect to the height direction (e.g., z-axis direction) of the terminal structure 300. For example, the decoration part 320 may be disposed in the positive z-axis direction of the connector part 330, and the cover part 310 may be disposed in the positive z-axis direction of the decoration part 320.

In an embodiment, the adhesive part 340 may be disposed between the cover part 310 and the decoration part 320. For example, the cover part 310 may be disposed in the positive z-axis direction with respect to the adhesive part 340, and the decoration part 320 may be disposed in the negative z-axis direction with respect to the adhesive part 340.

In an embodiment, the adhesive part 340 may be adhered to the cover part 310 on one side (e.g., the side facing in the positive z-axis direction) and adhered to the decoration part 320 on the other side (e.g., the side facing in the negative z-axis direction).

In an embodiment, the cover part 310 may include a coupling region 312. For example, two coupling regions 312 may be formed at mutually symmetrical positions with respect to the cover opening 311. The coupling region 312 may include a space into which the coupling member 350 is inserted.

In an embodiment, at least a portion of the decoration part 320 may protrude in a direction toward the connector part 330. For example, the conductive region 321 may be formed to extend from one side of the decoration part 320 so that at least a portion thereof protrudes in a direction toward the connector part 330.

In an embodiment, the support member 334 of the connector part 330 may include a support member opening 3341. The support member opening 3341 may be formed at one end and the other end of the support member 334.

In an embodiment, the support member 334 may serve to support the first connector 331 (refer to FIG. 3A).

With reference to FIGS. 4A and 4B, the flexible printed circuit board 333 of the connector part 330 may extend in a direction from the support member 334 and the first connector 331 (refer to FIG. 3A) toward the second connector 332.

In an embodiment, the coupling member 350 may serve to couple the cover part 310 and the connector part 330. The coupling member 350 may be disposed to penetrate the support member opening 3341 of the connector part 330 and be inserted into the coupling region 312 of the cover part 310. With reference to FIGS. 4A and 4B, the coupling member 350 may be disposed in the support member opening 3341 and the coupling region 312, so that the cover part 310 and the connector part 330 may be coupled to each other.

In an embodiment, the coupling member 350 may be a bolt having threads formed on its surface. For example, the coupling member 350 may be screw-fastened to the support member opening 3341 and the coupling region 312.

In an embodiment, the coupling member 350 may be a rivet made of a metal material. For example, the coupling member 350 formed in a rivet may be fixed to the support member opening 3341 and the coupling region 312.

In an embodiment, the terminal structure 300 may not include a separate coupling member 350. If the terminal structure 300 does not include a separate coupling member 350, the connector part 330 and the cover part 310 may be coupled by using welding or adhesion.

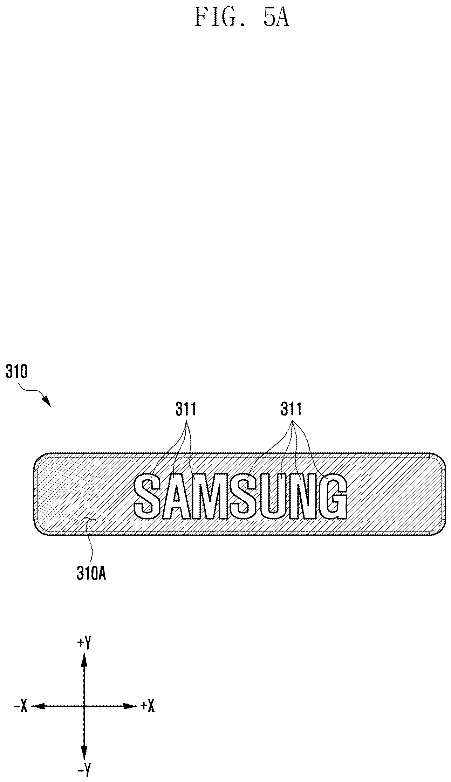

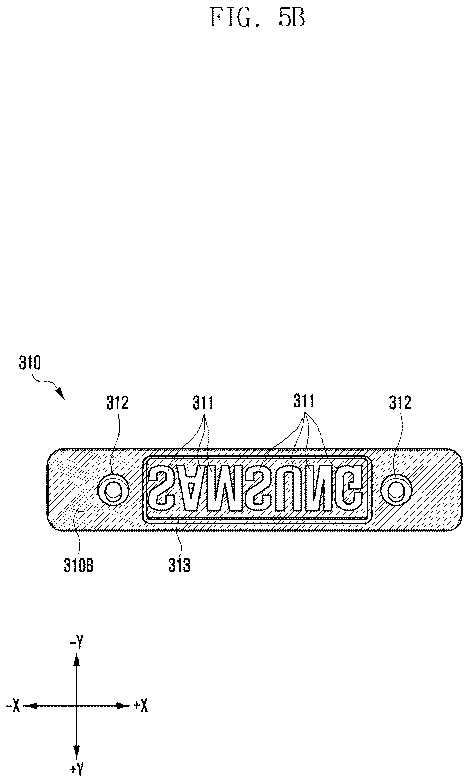

FIGS. 5A and 5B are views illustrating the cover part 310 according to an embodiment of the disclosure.

FIG. 5A is a view illustrating a first surface 310A of the cover part 310 according to an embodiment. FIG. 5B is a view illustrating a second surface 310B of the cover part 310, being the opposite side of the first surface 310A of the cover part 310 according to an embodiment.

In describing the cover part 310 according to an embodiment of the disclosure, the length direction of the cover part 310 may indicate the x-axis direction, and the width direction of the cover part 310 may indicate the y-axis direction.

In an embodiment, the cover part 310 may include a cover opening 311, a coupling region 312, and/or a perimeter region 313.

In an embodiment, the cover part 310 may be formed to extend along the length direction and the width direction. For example, the cover part 310 may be formed in a plate shape that extends in the length direction and width direction and has a thickness in a direction perpendicular to the length direction and width direction.

In an embodiment, one or more cover openings 311 may be formed in the cover part 310. The cover opening 311 may be formed in a shape substantially identical to the perimeter of the conductive region 321 (refer to FIG. 3A).

In an embodiment, the first surface 310A of the cover part 310 may refer to the surface facing the outside of the electronic device 200 (refer to FIG. 2A). The second surface 310B of the cover part 310 may refer to the surface of the cover part 310 facing the decoration part 320.

In an embodiment, the cover part 310 may include at least one coupling region 312. The coupling region 312 may be a region into which the coupling member 350 (refer to FIG. 4A) is inserted.

In an embodiment, the coupling region 312 may be formed on the second surface 310B of the cover part 310.

In an embodiment, at least one coupling region 312 may be formed at symmetrical positions with respect to the cover opening 311. For example, with reference to FIG. 5B, coupling regions 312 may be formed in one direction (e.g., positive x-axis direction) and the other direction (e.g., negative x-axis direction) with respect to the cover opening 311.

In an embodiment, the perimeter region 313 may be formed to surround the cover opening 311 at the outer periphery of the cover opening 311.

In an embodiment, the perimeter region 313 may serve to guide the position where the adhesive member 340 (refer to FIG. 3A) is disposed. For example, the perimeter region 313 may be formed to extend in the shape of the perimeter of the adhesive member 340 and serve to guide the adhesive member 340 to be disposed at a specified position in the cover part 310.

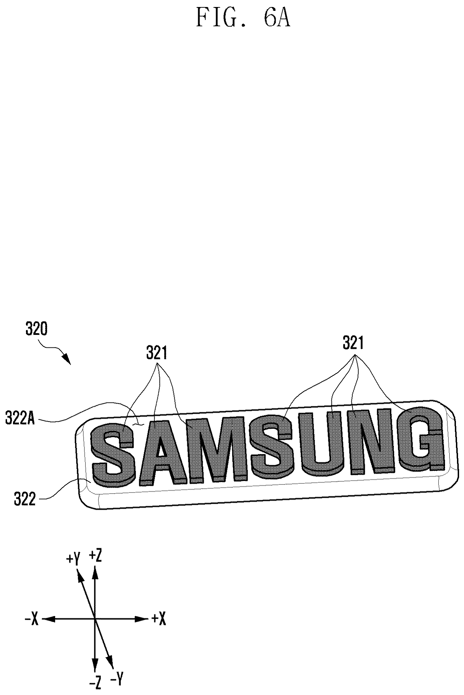

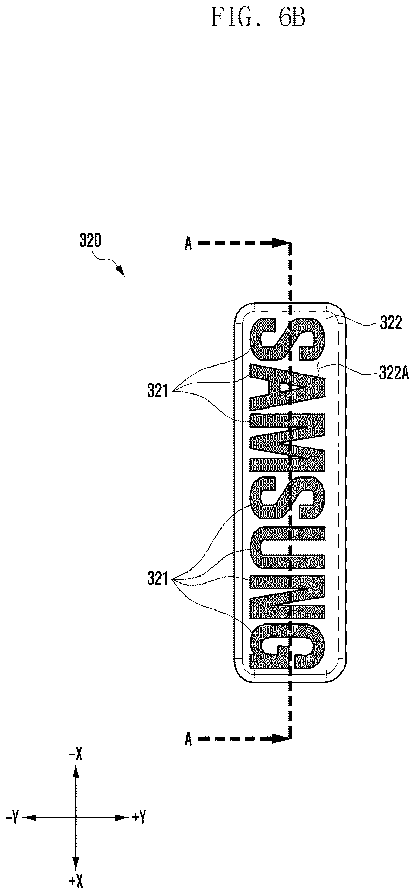

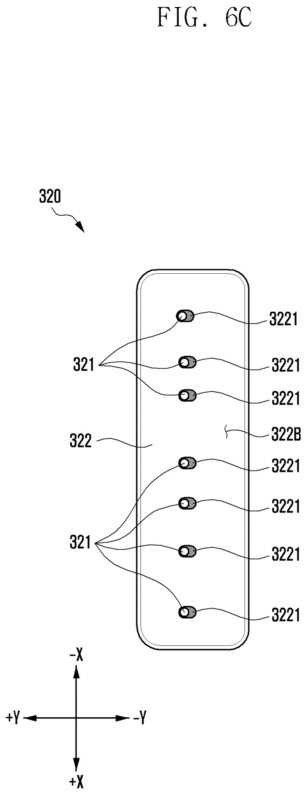

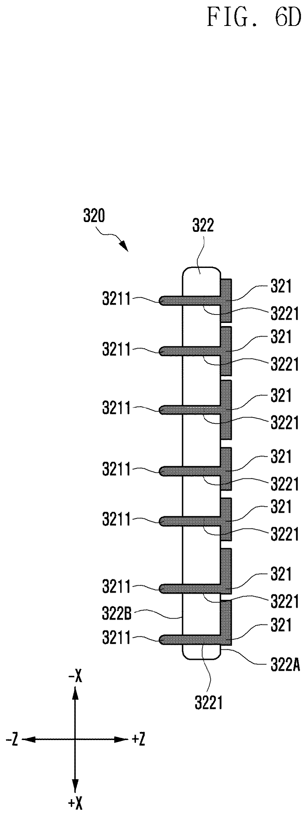

FIGS. 6A, 6B, 6C and 6D are views illustrating the decoration part 320 according to an embodiment of the disclosure.

FIG. 6A is a perspective view of the decoration part 320 according to an embodiment. FIG. 6B is a view illustrating a first surface 322A of the non-conductive region 322 according to an embodiment. FIG. 6C is a view illustrating a second surface 322B of the non-conductive region 322 according to an embodiment. FIG. 6D is a cross-sectional view of the decoration part 320 taken along line A-A in FIG. 6B.

In describing the decoration part 320 according to an embodiment of the disclosure, the length direction of the decoration part 320 may indicate the x-axis direction, and the width direction may indicate the y-axis direction. The height direction of the decoration part 320 may indicate the z-axis direction.

In an embodiment, the decoration part 320 may include a plate shape that extends in the width and length directions of the decoration part 320 and has a thickness in the height direction of the decoration part 320.

With reference to FIGS. 6A and 6B, the decoration part 320 according to an embodiment may include a conductive region 321 and/or a non-conductive region 322.

With reference to FIGS. 6A and 6D, the conductive region 321 may be formed to have a specified thickness on one surface of the non-conductive region 322. For example, at least a portion of the conductive region 321 may be formed to have a thickness in a direction away from the first surface 322A of the non-conductive region 322.

With reference to FIG. 6A, a portion of the conductive region 321 (e.g., a portion of the conductive region 321 formed to have a specified thickness on one surface of the non-conductive region 322) may be formed in a preset shape. For example, with reference to FIG. 6A, a portion of the conductive region 321 may be formed in the shape of a letter. However, the letter shape of the conductive region 321 illustrated in FIG. 6A is exemplary, and a portion of the conductive region 321 may be formed in the shape of a letter, a number, a symbol, or a combination thereof.

With reference to FIG. 6D, the conductive region 321 may include a protrusion 3211 formed to protrude from the second surface 322B of the non-conductive region 322. For example, the protrusion 3211 of the conductive region 321 may extend to protrude in a direction away from the second surface 322B of the non-conductive region 322.

In an embodiment, one end of the conductive region 321 may be in contact with the connector part 330 (refer to FIG. 3A). For example, the protrusion of the conductive region 321 may be in contact with the connector terminal 3311 of the connector part 330 (refer to FIG. 3A).

In an embodiment, the other end of the conductive region 321 may be exposed to the outside of the electronic device 200 (refer to FIG. 2A) through a housing opening 211a (refer to FIG. 2A).

In an embodiment, the conductive region 321 may be a region whose other end (e.g., end portion in positive z-axis direction in FIG. 6D) is exposed to the outside of the electronic device 200 (refer to FIG. 2A) for executing a specified function. For example, the conductive region 321 may be a region that is in contact with an apparatus outside the electronic device 200 to receive power. Alternatively, the conductive region 321 may be a region for data transmission, grounding, identification of an external device, and/or a magnetic function.

In an embodiment, the non-conductive region 322 may include one or more non-conductive openings 3221. The one or more non-conductive openings 3221 may be arranged at regular intervals along the length direction (e.g., x-axis direction) of the decoration part 320.

In an embodiment, the non-conductive opening 3221 may be formed at a position corresponding to the conductive region 321. For example, with reference to FIGS. 6C and 6D, at least a portion of the conductive region 321 may be disposed to penetrate the non-conductive opening 3221.

With reference to FIG. 6C, the width of the non-conductive opening 3221 may be formed to be longer than the width of the protrusion 3211 of the conductive region 321. The width of the protrusion 3211 may be changed based on the shape of the conductive region 321 within a range of the length less than the width of the non-conductive opening 3221.

In an embodiment, the conductive region 321 may include a conductive material. For example, the conductive region 321 may include a conductive material (e.g., metal) having electrical conductivity and may come into contact with an external device to be electrically connected.

In an embodiment, the conductive region 321 may include an elastic material. If the conductive region 321 includes an elastic material, the conductive region 321 may come into contact with the connector part 330 (refer to FIG. 3A), and the length of the conductive region 321 (e.g., the length of the conductive region 321 in the z-axis direction) may be elastically changed. In an embodiment, the conductive region 321 may include at least one pogo pin. Each pogo pin may include a plunger, a spring, and/or a barrel. In an embodiment, the conductive region 321 may include at least one pin. Each pin may include a leaf spring.

In an embodiment, the non-conductive region 322 may include a non-conductive material. For example, the non-conductive region 322 may include a non-conductive material having electrical insulation properties, and may be disposed to surround at least a portion of the conductive region 321 including a conductive material.

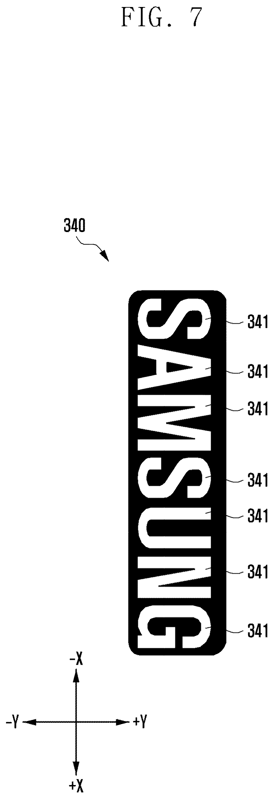

FIG. 7 is a view illustrating the adhesive part 340 according to an embodiment of the disclosure.

In describing the adhesive part 340 according to an embodiment of the disclosure, the length direction of the adhesive part 340 may indicate the x-axis direction, and the width direction of the adhesive part 340 may indicate the y-axis direction.

In an embodiment, the adhesive part 340 may be formed in a plate shape extending in the length direction and width direction of the adhesive part 340.

In an embodiment, the adhesive part 340 may be formed to have substantially the same shape as the perimeter region 313 (refer to FIG. 5B) of the cover part 310 (refer to FIG. 5B).

In an embodiment, the adhesive part 340 may serve to couple the cover part 310 (refer to FIG. 3A) and the decoration part 320 (refer to FIG. 3A). For example, the cover part 310 may be adhered to one side of the adhesive part 340, and the decoration part 320 may be adhered to the other side of the adhesive part 340, so that the cover part 310 and the decoration part 320 may be coupled with each other.

In an embodiment, the adhesive part 340 may include an adhesive part opening 341. The adhesive part opening 341 may be formed in a shape substantially identical to the perimeter of the conductive region 321 (refer to FIG. 3A) of the decoration region 320 (refer to FIG. 3A). The conductive region 321 may be disposed to penetrate the adhesive part opening 341.

In an embodiment, the adhesive part 340 may include an adhesive material. For example, the adhesive part 340 may be a double-sided tape containing an adhesive material. Alternatively, the adhesive part 340 may be a thermosetting adhesive or a pressure sensitive adhesive (PSA).

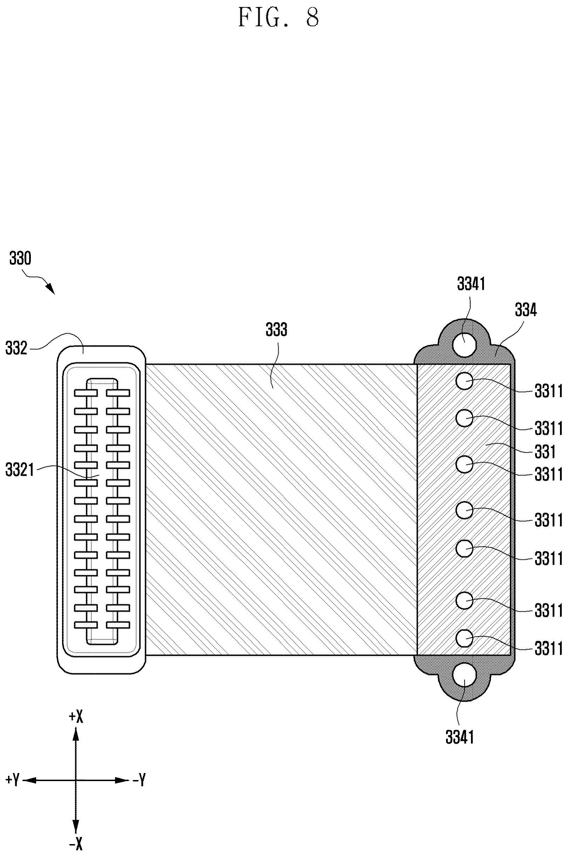

FIG. 8 is a view illustrating the connector part 330 according to an embodiment of the disclosure.

In describing the connector part 330 according to an embodiment of the disclosure, the length direction of the connector part 330 may indicate the y-axis direction, and the width direction of the connector part 330 may indicate the x-axis direction.

In an embodiment, the connector part 330 may include a first connector 331, a second connector 332, a flexible printed circuit board 333, and/or a support member 334.

In an embodiment, the first connector 331 may be disposed at one end of the flexible printed circuit board 333. The second connector 332 may be disposed at the other end of the flexible printed circuit board 333.

In an embodiment, the first connector 331 may include at least one connector terminal 3311. Each of the at least one connector terminal 3311 may come into contact with the conductive region 321 of the decoration part 320 to be electrically connected.

In an embodiment, the plurality of connector terminals 3311 may be arranged at specific intervals. For example, with reference to FIG. 8, the connector terminals 3311 may be arranged at specific intervals in the width direction (e.g., in the x-axis direction) of the connector part 330.

In an embodiment, the second connector 332 may include a first connector pin region 3321. The first connector pin region 3321 may be a region electrically connected to an external printed circuit board 820 (refer to FIG. 13A).

In an embodiment, the flexible printed circuit board 333 may be formed to extend between the first connector 331 and the second connector 332. For example, the flexible printed circuit board 333 may extend along the length direction (e.g., y-axis direction) of the connector part 330 between the first connector 331 and the second connector 332.

In an embodiment, the flexible printed circuit board 333 may be electrically connected to the first connector 331 at one end and electrically connected to the second connector 332 at the other end. For example, the flexible printed circuit board 333 may be electrically connected to the connector terminal 3311 of the first connector 331 at one end and electrically connected to the first connector pin region 3321 of the second connector 332 at the other end.

In an embodiment, the flexible printed circuit board 333 may include a material different from that of the first connector 331 and the second connector 332. For example, the flexible printed circuit board 333 may be made of a material that is readily bendable. The first connector 331 and the second connector 332 may be made of a material having higher rigidity than the flexible printed circuit board 333.

In an embodiment, the support member 334 may serve to support the first connector 331. For example, the first connector 331 may be disposed on one surface of the support member 334 to be supported by the support member 334.

In an embodiment, the support member 334 may include a support member opening 3341 at one end and the other end. The coupling member 350 (refer to FIG. 4A) for coupling the cover part 310 (refer to FIG. 4A) and the connector part 330 may be inserted into the support member opening 3341.

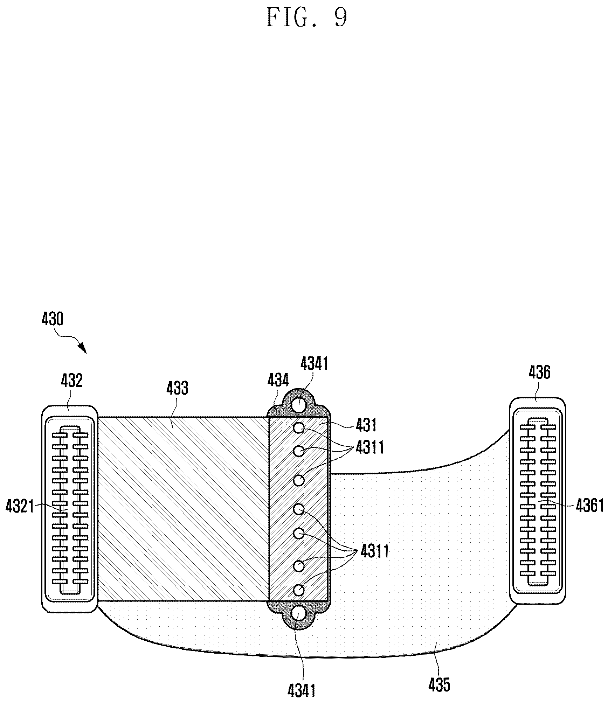

FIG. 9 is a view illustrating a connector part 430 including a second flexible printed circuit board 435 connected to a second connector 432 according to an embodiment of the disclosure.

The connector part 430 according to an embodiment of the disclosure may include a first connector 431, a second connector 432, a first flexible printed circuit board 433, a support member 434, a second flexible printed circuit board 435, and/or a third connector 436.

The shape, function and arrangement of the first connector 431, second connector 432, first flexible printed circuit board 433, and support member 434 shown in FIG. 9 may be substantially the same as the shape, function and arrangement of the first connector 331, second connector 332, flexible printed circuit board 333, and support member 334 shown in FIG. 8.

In an embodiment, the first connector 431 may include at least one connector terminal 4311.

In an embodiment, the second connector 432 may include a first connector pin region 4321.

In an embodiment, the support member 434 may include a support member opening 4341 at one end and the other end.

In an embodiment, the third connector 436 may include a second connector pin region 4361. The second connector pin region 4361 may be a region electrically connected to an external printed circuit board 820 (refer to FIG. 13A).

In an embodiment, the first flexible printed circuit board 433 may be formed to extend between the first connector 431 and the second connector 432.

In an embodiment, the first connector 431 may be disposed at one end of the first flexible printed circuit board 433, and the second connector 432 may be disposed at the other end of the first flexible printed circuit board 433. The first connector 431 and the second connector 432 may be electrically connected to the first flexible printed circuit board 433.

In an embodiment, the second flexible printed circuit board 435 may be formed to extend between the second connector 432 and the third connector 436.

In one embodiment, the third connector 436 may be disposed at one end of the second flexible printed circuit board 435, and the second connector 432 may be disposed at the other end of the second flexible printed circuit board 435. The second connector 432 and the third connector 436 may be electrically connected to the second flexible printed circuit board 435.

In an embodiment, the first flexible printed circuit board 433 and the second flexible printed circuit board 435 may include a material different from that of the first connector 431, the second connector 432, and the third connector 436. For example, the first flexible printed circuit board 433 and the second flexible printed circuit board 435 may be made of a material that is readily bendable. The first connector 431, the second connector 432, and the third connector 436 may be made of a material having higher rigidity than the first flexible printed circuit board 433 and the second flexible printed circuit board 435.

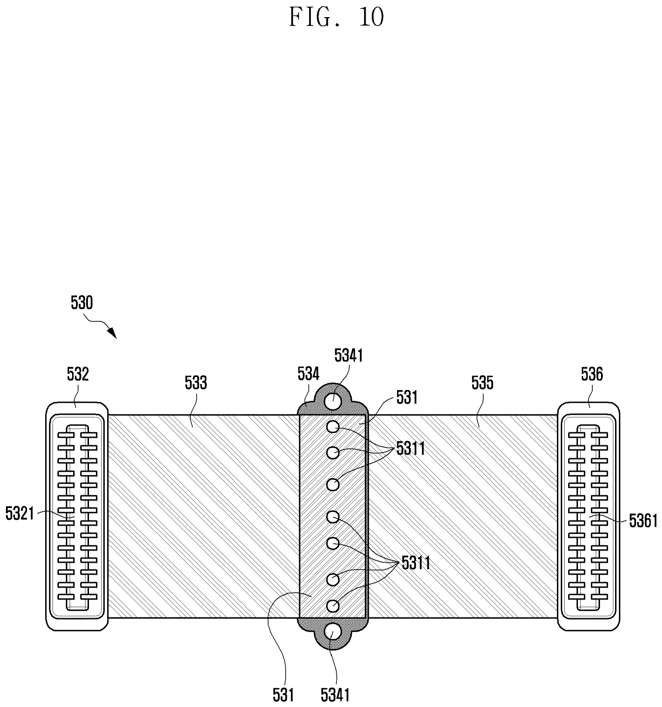

FIG. 10 is a view illustrating a connector part 530 including a second flexible circuit board 535 connected to a first connector 531 according to an embodiment of the disclosure.

The connector part 530 according to an embodiment of the disclosure may include a first connector 531, a second connector 532, a first flexible printed circuit board 533, a support member 534, and/or a second flexible printed circuit board 535.

The shape, function and arrangement of the first connector 531, second connector 532, first flexible printed circuit board 533 and support member 534 shown in FIG. 10 may be substantially the same as the shape, function and arrangement of the first connector 331, second connector 332, flexible printed circuit board 333 and support member 334 shown in FIG. 8.

In an embodiment, the first connector 531 may include at least one connector terminal 5311.

In an embodiment, the second connector 532 may include a first connector pin region 5321.

In an embodiment, the support member 534 may include a support member opening 5341 at one end and the other end.

In an embodiment, the third connector 536 may include a second connector pin region 5361. The second connector pin region 5361 may be a region electrically connected to an external printed circuit board 820 (refer to FIG. 13A).

In an embodiment, the first flexible printed circuit board 533 may be formed to extend between the first connector 531 and the second connector 532.

In an embodiment, the first connector 531 may be disposed at one end of the first flexible printed circuit board 533, and the second connector 532 may be disposed at the other end of the first flexible printed circuit board 533. The first connector 531 and the second connector 532 may be electrically connected to the first flexible printed circuit board 533.

In an embodiment, the second flexible printed circuit board 535 may be formed to extend between the first connector 531 and the third connector 536.

In an embodiment, the third connector 536 may be disposed at one end of the second flexible printed circuit board 535, and the first connector 531 may be disposed at the other end of the second flexible printed circuit board 535. The first connector 531 and the third connector 536 may be electrically connected to the second flexible printed circuit board 535.

In an embodiment, the first flexible printed circuit board 533 and the second flexible printed circuit board 535 may include a material different from that of the first connector 531, the second connector 532, and the third connector 536. For example, the first flexible printed circuit board 533 and the second flexible printed circuit board 535 may be made of a material that is readily bendable. The first connector 531, the second connector 532, and the third connector 536 may be made of a material having higher rigidity than the first flexible printed circuit board 533 and the second flexible printed circuit board 535.

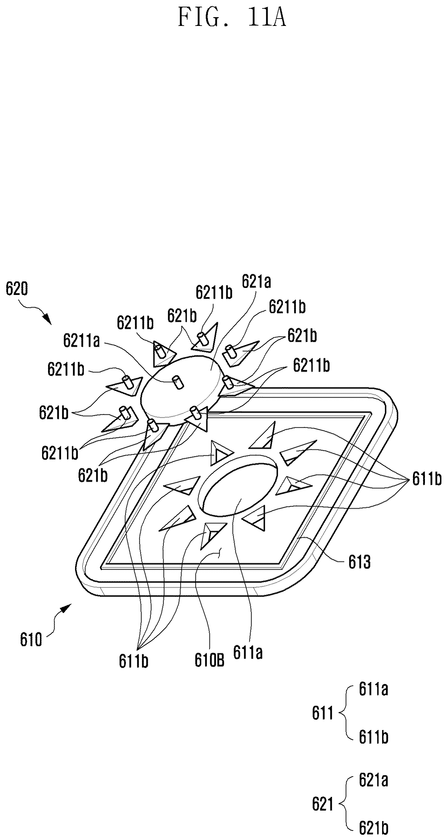

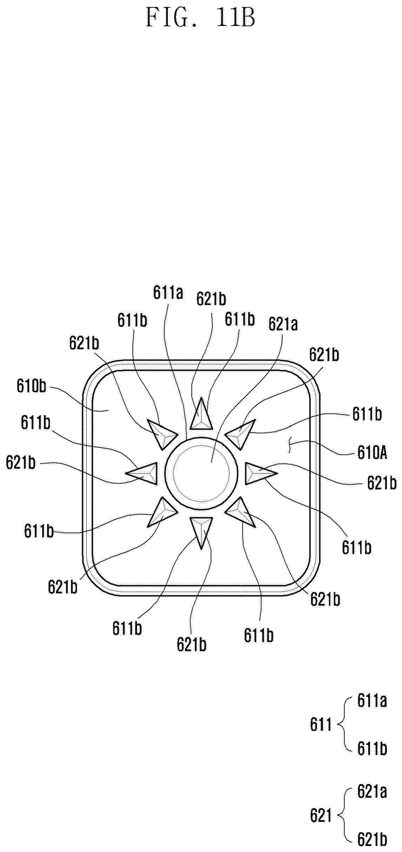

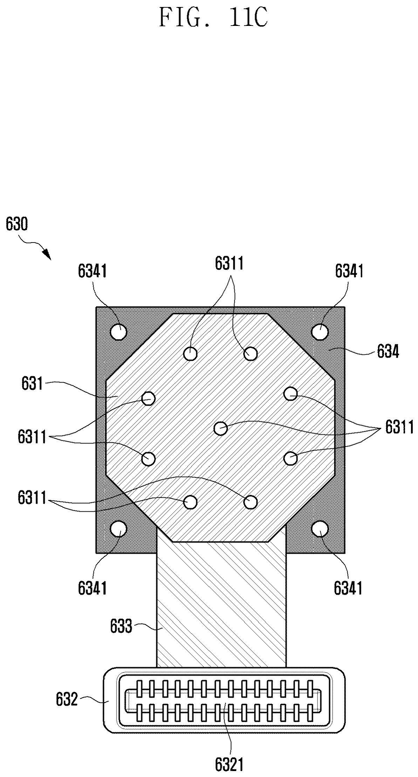

FIGS. 11A, 11B and 11C are views illustrating a cover part 610, a decoration part 620 and a connector part 630 according to an embodiment of the disclosure.

FIG. 11A is a perspective view illustrating the cover part 610 and the decoration part 620 according to an embodiment. FIG. 11B is a view illustrating a first surface 610A of the cover part 610 according to an embodiment. FIG. 11C is a view illustrating the connector part 630 according to an embodiment.

The functions of the cover part 610, decoration part 620, and connector part 630 shown in FIGS. 11A, 11B and 11C may be substantially the same as those of the cover part 310, decoration part 320, and connector part 330 shown in FIG. 3A, respectively.

With reference to FIG. 11A, the cover part 610 may include a polygonal shape. For example, the cover part 610 may include a square-shaped plate.

The shape of the cover part 610 shown in FIG. 11A is exemplary, and the shape of the cover part 610 may be not limited thereto. For example, the cover part 610 may be formed in a polygonal shape or circular shape other than a square shape.

In an embodiment, the cover part 610 may include a cover opening 611 and/or a perimeter region 613.

In an embodiment, the cover part 610 may include at least one cover opening 611. For example, the cover part 610 may include a first cover opening 611a and/or a plurality of second cover openings 611b arranged to surround the first cover opening 611a.

In an embodiment, some of the at least one cover opening 611 may be formed in a shape different from that of the others. For example, the first cover opening 611a may be formed to have a circular cross-section, and the second cover openings 611b may be formed to have a triangular cross-section.

In an embodiment, the perimeter region 613 may be formed to be extended to surround the outer perimeter of the cover opening 611. When a separate adhesive member 340 (refer to FIG. 3A) is disposed between the cover part 610 and the decoration part 620, the perimeter region 613 may serve to guide the position where the adhesive member 340 (refer to FIG. 3A) is placed.

In an embodiment, the decoration part 620 may include a conductive region 621. The conductive region 621 may be a region that includes a conductive material.

In an embodiment, the conductive region 621 may include a first conductive region 621a and/or a plurality of second conductive regions 621b arranged to surround the first conductive region 621a.

In an embodiment, the conductive region 621 of the decoration part 620 may include a figure shape. With reference to FIG. 11A, the conductive region 621 may be formed in a circular or triangular shape. For example, the first conductive region 621a may be formed in a circular plate shape. The second conductive region 621b may be formed in a triangular plate shape.

The shape of the conductive region 621 shown in FIG. 11A is exemplary, and the shape of the conductive region 621 may be not limited thereto. For example, the conductive region 621 may be formed in a polygonal shape other than a triangular shape.

In an embodiment, the cover opening 611 may be formed in a shape corresponding to the shape of the conductive region 621. For example, if the conductive region 621 includes circular and triangular shapes, the cover opening 611 may include circular and triangular shapes. The first cover opening 611a may be formed in a shape substantially identical to the perimeter of the first conductive region 621a. The second cover opening 611b may be formed in a shape substantially identical to the perimeter of the second conductive region 621b.

In an embodiment, the decoration part 620 may further include a non-conductive region 322 (refer to FIG. 6A) surrounding the conductive region 621. The non-conductive region 322 (refer to FIG. 6A) may include a non-conductive material.

With reference to FIGS. 11A and 11B, the conductive region 621 may be disposed to penetrate the cover opening 611. The conductive region 621 may be disposed on the cover part 610 in a direction toward the second surface 610B of the cover part 610, so that at least a portion thereof may penetrate the cover opening 611.

With reference to FIG. 11B, at least a portion of the conductive region 621 may be exposed to the outside of the cover part 610 on the first surface 610A of the cover part 610.

In an embodiment, the conductive region 621 may include a protrusion 6211a or 6211b. The protrusion 6211a or 6211b may be extended to protrude in the opposite direction of the cover part 610 in the conductive region 621. In the first conductive region 621a, the first protrusion 6211a may extend in the opposite direction of the cover part 610. In the second conductive region 621b, the second protrusion 6211b may extend in the opposite direction of the cover part 610.

In an embodiment, the connector part 630 may include a first connector 631, a second connector 632, a flexible printed circuit board 633, and/or a support member 634.

In an embodiment, the functions of the first connector 631, second connector 632, flexible printed circuit board 633, and support member 634 may be substantially the same as the functions of the first connector 331, second connector 332, flexible printed circuit board 333, and support member 334 illustrated in FIG. 8.

In an embodiment, the first connector 631 may include at least one connector terminal 6311. The connector terminal 6311 may be formed at a position where the protrusion 6211a or 6211b of the conductive region 621 is disposed.

In an embodiment, the connector terminal 6311 may come into contact with the protrusion 6211a or 6211b of the conductive region 621 to be electrically connected.

In an embodiment, the flexible printed circuit board 633 may be extended to the first connector 631 and the second connector 632.

In an embodiment, the first connector 631 and the second connector 632 may be made of a material having higher rigidity than the flexible printed circuit board 633.

In an embodiment, the support member 634 may include at least one support member opening 6341. The support member opening 6341 may be an opening into which the coupling member 350 (refer to FIG. 4A) is inserted. When the coupling member 350 is inserted into the support member opening 6341, the connector part 630 and the cover part 610 may be coupled.

In an embodiment, the second connector 632 may include a first connector pin region 6321 that is electrically connected to an external printed circuit board 820 (refer to FIG. 13A).

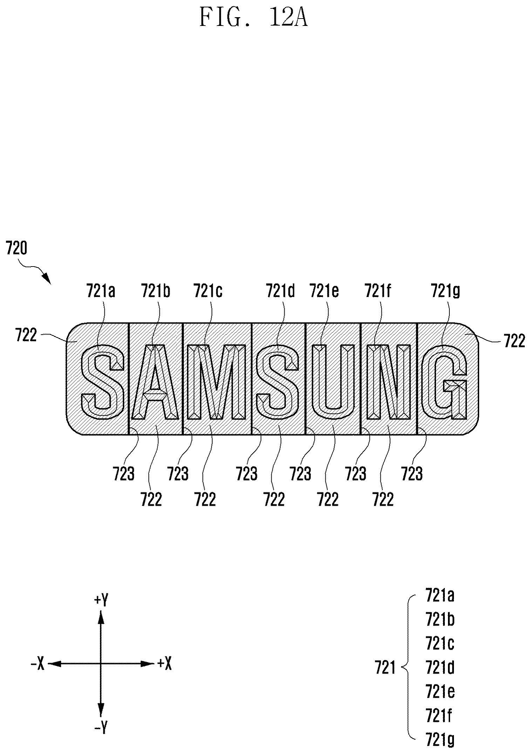

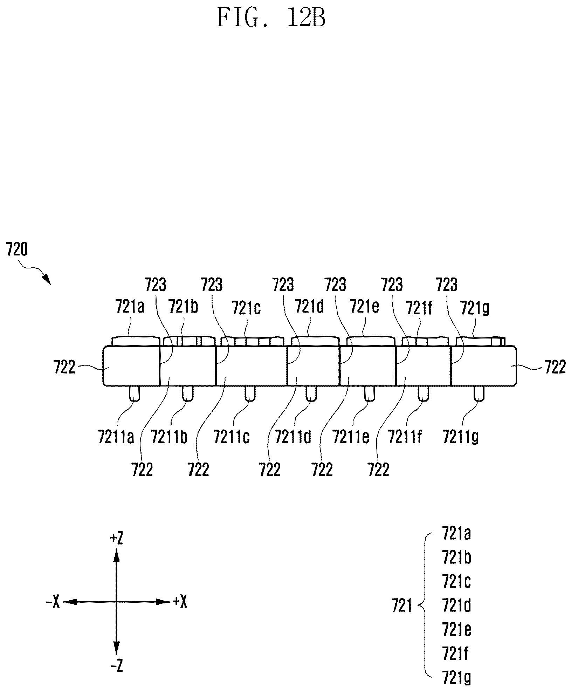

FIGS. 12A and 12B are views illustrating the decoration part 720 according to an embodiment of the disclosure.

The decoration part 720 shown in FIGS. 12A and 12B may refer to the decoration part 320 illustrated in FIG. 3A.

The decoration part 720 illustrated in FIGS. 12A and 12B may be substantially the same as the decoration part 320 illustrated in FIG. 3A in terms of function, shape, and placement location. For example, the decoration part 720 illustrated in FIGS. 12A and 12B may be disposed between the cover part 310 and the connector part 330.

The decoration part 720 according to an embodiment of the disclosure may further include a conductive region 721, a non-conductive region 722, and/or an insulating member 723.

The decoration part 720 illustrated in FIGS. 12A and 12B may further include the insulating member 723 compared to the decoration part 320 shown in FIG. 3A.

In an embodiment, the non-conductive region 722 may be disposed to surround the conductive region 721.

In an embodiment, a portion of the conductive region 721 may be formed to have a thickness in one direction on one side of the non-conductive region 722. A portion of the conductive region 721 may be formed to protrude by a specific length in a direction away from the other side of the non-conductive region 722.

In an embodiment, the conductive region 721 may include at least one unit conductive region (e.g., 721a). For example, the conductive region 721 may include a first conductive region 721a, a second conductive region 721b, a third conductive region 721c, a fourth conductive region 721d, a fifth conductive region 721e, a sixth conductive region 721f, and/or a seventh conductive region 721g.

In an embodiment, each conductive region 721 may be a region for performing a given function (e.g., power supply, data transfer, grounding). For example, the first conductive region 721a and the seventh conductive region 721g may be a magnet for physical coupling with an external device. The second conductive region 721b and the third conductive region 721c may be a power terminal for receiving power supplied from the outside to the electronic device 200 (refer to FIG. 2A). The fourth conductive region 721d and the fifth conductive region 721e may be a ground terminal. The sixth conductive region 721f may be a terminal for data transmission.

In an embodiment, the conductive region 721 may include a terminal for supplying power to an external electronic device (e.g., digital pen). For example, the first conductive region 721a may be a power terminal for supplying power to an external electronic device.

In an embodiment, the conductive region 721 may include a terminal for identifying an external electronic device. For example, the seventh conductive region 721g may be a terminal for identifying an external electronic device.

In an embodiment, the conductive regions 721 may be disposed with the insulating member 723 interposed therebetween. For example, with reference to FIGS. 12A and 12B, the insulating members 723 may be disposed respectively between the first conductive region 721a and the second conductive region 721b, the second conductive region 721b and the third conductive region 721c, the third conductive region 721c and the fourth conductive region 721d, the fourth conductive region 721d and the fifth conductive region 721e, the fifth conductive region 721e and the sixth conductive region 721f, and the sixth conductive region 721f and the seventh conductive region 721g.

In an embodiment, the insulating member 723 may include an insulating material. The insulating members 723 may prevent individual unit conductive regions (e.g., 721a) from being electrically connected to each other.

In an embodiment, the insulating member 723 may serve to enable the conductive regions 721 to perform different functions. For example, if the third conductive region 721c is a power terminal and the fourth conductive region 721d is a ground terminal, the insulating member 723 may be disposed between the third conductive region 721c and the fourth conductive region 721d to prevent the third conductive region 721c and the fourth conductive region 721d from being electrically connected, so that the third conductive region 721c may function as a power terminal and the fourth conductive region 721d may function as a ground terminal.

In an embodiment, the insulating member 723 may be formed in the shape of a film having a preset thickness. For example, the insulating member 723 may be formed in a film shape that separates individual unit conductive regions (e.g., 721a).

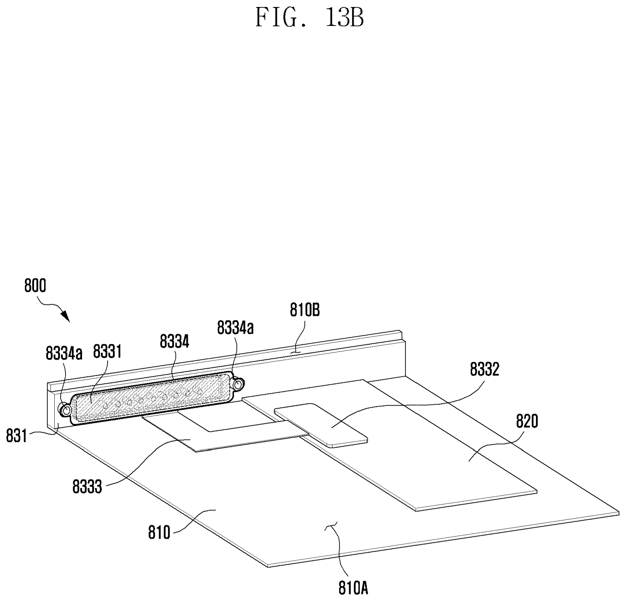

FIGS. 13A and 13B are views illustrating an electronic device 800 according to an embodiment of the disclosure.

FIG. 13A is an exploded perspective view of the electronic device 800 according to an embodiment. FIG. 13B is a view illustrating the electronic device 800 according to an embodiment.

The electronic device 800 shown in FIGS. 13A and 13B may refer to the electronic device 200 of FIG. 2A or may include at least some of the electronic device 200 of FIG. 2A.

The electronic device 800 according to an embodiment of the disclosure may include a housing 810, a printed circuit board 820, and/or a terminal structure 830.

In an embodiment, the terminal structure 830 may include a cover part 831, a decoration part 832, and/or a connector part 833.

In an embodiment, the housing 810 may be a structure constituting the external appearance of the electronic device 800. The housing 810 may serve to protect electronic components (e.g., printed circuit board 820) arranged inside the electronic device 800. The printed circuit board 820 may be disposed on the first surface 810A of the housing 810.

In an embodiment, the housing 810 may include at least one surface. For example, the housing 810 may include a first surface 810A and/or a second surface 810B.

In FIGS. 13A and 13B, the housing 810 is depicted as including two surfaces, but this is an example for explanation, and the number of surfaces included in the housing 810 may be not limited thereto. For example, the housing 810 may be formed in a rectangular parallelepiped shape to thereby include six surfaces.

With reference to FIGS. 13A and 13B, the cover part 831 of the terminal structure 830 may be disposed on the second surface 810B of the housing 810. For example, the cover part 831 may be disposed so that at least a portion thereof is in direct contact with the second surface 810B of the housing 810.

In an embodiment, the second surface 810B of the housing 810 and the cover part 831 of the terminal structure 830 may be formed integrally. For example, the cover part 831 may be included in the second surface 810B of the housing 810.

In an embodiment, the cover part 831 may include a cover opening 8311. An opening having substantially the same shape as the cover opening 8311 may be formed at a portion of the housing 810 where the cover opening 8311 is disposed.

In an embodiment, the cover part 831 may include a coupling region 8312. The coupling regions 8312 may be formed in one direction and the other direction with respect to the cover opening 8311.

In an embodiment, the decoration part 832 may include a conductive region 8321 and/or a non-conductive region 8322.

In an embodiment, at least a portion of the conductive region 8321 may be disposed to penetrate the cover opening 8311. For example, at least a portion of the conductive region 8321 may extend in a direction toward the cover part 831 and the housing 810 to penetrate the cover opening 8311 and be exposed outside the housing 810.

In an embodiment, at least a portion of the conductive region 8321 may extend to protrude toward the connector part 833. For example, a portion of the conductive region 8321 may extend from one side of the non-conductive region 8322 toward the first connector 8331 of the connector part 833.

In an embodiment, the connector part 833 may include a first connector 8331, a second connector 8332, a flexible printed circuit board 8333, and/or a support member 8334.

With reference to FIG. 13A, the first connector 8331 may include at least one connector terminal 8331a. The connector terminal 8331a of the first connector 8311 may be arranged on a surface of the first connector 8311 facing the decoration part 832.

With reference to FIGS. 13A and 13B, the first connector 8331 may be coupled to the decoration part 832. When the first connector 8331 is coupled to the decoration part 832, the connector terminal 8331a of the first connector 8311 and the conductive region 8321 of the decoration part 832 may come into contact. The connector terminal 8331a and the conductive region 8321 may come into contact to be electrically connected to each other.

With reference to FIGS. 13A and 13B, the cover part 831 may be disposed in one direction of the decoration part 832, and the first connector part 833 may be disposed in the other direction of the decoration part 832.

In an embodiment, the flexible printed circuit board 8333 may extend between the first connector 8331 and the second connector 8332. The flexible printed circuit board 8333 may serve to electrically connect the first connector 8331 and the second connector 8332. The flexible printed circuit board 8333 may be electrically connected to the first connector 8331 at one end and electrically connected to the second connector 8332 at the other end.

In an embodiment, the second connector 8332 may be disposed on the printed circuit board 820. For example, the second connector 8332 may be disposed on one surface of the printed circuit board 820 and electrically connected to the printed circuit board 820.

In an embodiment, the support member 8334 may serve to support the first connector 8331. For example, the first connector 8331 may be disposed on one surface of the support member 8334 (e.g., the surface of the support member 8334 facing the decoration part 832) to be supported by the support member 8334.

In an embodiment, the support member 8334 may include a support member opening 8334a at one end and the other end. The support member opening 8334a may be disposed in the coupling region 8312 of the cover part 831. A separate coupling member (e.g., 350, refer to FIG. 4A) may be inserted into the support member opening 8334a to thereby couple the cover part 831 and the connector part 833.

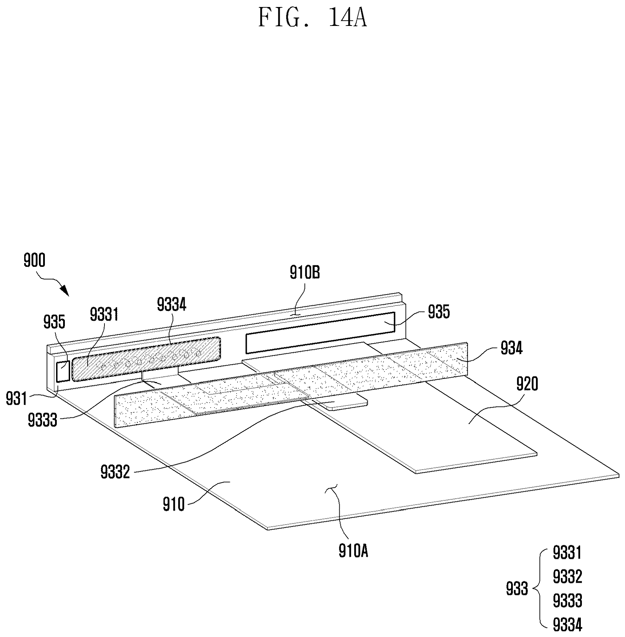

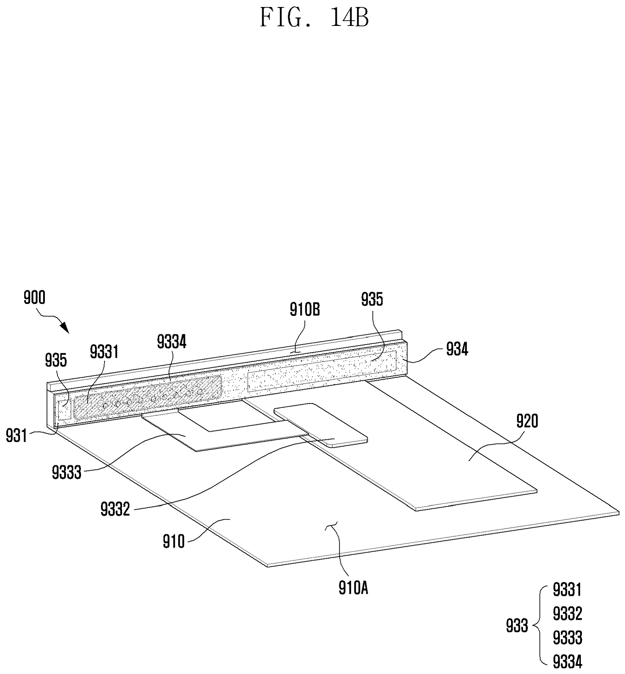

FIGS. 14A and 14B are views illustrating an electronic device 900 including a bracket 934 according to an embodiment of the disclosure.

FIG. 14A is a view illustrating the electronic device 900 in a state before the bracket 934 is coupled thereto according to an embodiment. FIG. 14B is a view illustrating the electronic device 900 in a state after the bracket 934 is coupled thereto according to an embodiment.

The electronic device 900 illustrated in FIGS. 14A and 14B may refer to the electronic device 200 of FIG. 2A or may include at least some of the electronic device 200 of FIG. 2A.

The electronic device 900 according to an embodiment of the disclosure may include a housing 910, a printed circuit board 920, and/or a terminal structure 930.

The shape, function and arrangement of the housing 910, printed circuit board 920 and terminal structure 930 illustrated in FIGS. 14A and 14B may be substantially the same as the shape, function and arrangement of the housing 810, printed circuit board 820 and terminal structure 830 illustrated in FIGS. 13A and 13B.

In an embodiment, the terminal structure 930 may include a cover part 931, a decoration part 832 (refer to FIG. 13A), a connector part 933, a bracket 934, and/or an adhesive member 935.

In an embodiment, the connector part 933 may include a first connector 9331, a second connector 9332, a flexible printed circuit board 9333, and/or a support member 9334.

In the terminal structure 930 illustrated in FIGS. 14A and 14B, the decoration part 832 illustrated in FIG. 13A may be disposed between the cover part 931 and the first connector 9331 of the connector part 933.

In an embodiment, the adhesive member 935 may be disposed on one surface of the cover part 931. The adhesive member 935 may be disposed in a region of the cover part 931 where the first connector 9331 is not disposed. For example, the adhesive member 935 may be disposed on one surface of the cover part 931 with a gap in one direction and the other direction with respect to the first connector 9331.

In an embodiment, the adhesive member 935 may include an adhesive material. For example, the adhesive member 935 may be a double-sided tape containing an adhesive material. Alternatively, the adhesive member 935 may be a thermosetting adhesive or a pressure sensitive adhesive (PSA).

In an embodiment, the bracket 934 may be formed to extend in a shape corresponding to the cover part 931. For example, if the cover part 931 is formed in a plate shape extending in one direction, the bracket 934 may be formed in a plate shape extending in a direction substantially parallel to the cover part 931.

In FIGS. 14A and 14B, the bracket 934 is depicted as being transparent, but this is an example for explanation, and the material of the bracket 934 may be not limited to a transparent material.

In an embodiment, the adhesive member 935 may be coupled to the cover part 931 on one side and to the bracket 934 on the other side. The bracket 934 may be coupled to the cover part 931 through the adhesive member 935.

In an embodiment, the bracket 934 may be disposed to cover the cover part 931 and the first connector 9331. For example, the bracket 934 may be disposed to cover at least a portion of the cover part 931 and the first connector 9331 in one direction of the cover part 931 and the first connector 9331.

In an embodiment, the bracket 934 may serve to couple the cover part 931, the decoration part 832 (refer to FIG. 13A), the first connector 9331, and the support member 9334 together. For example, the bracket 934 may be coupled to the cover part 931 through the adhesive member 935, and may serve to fix the positions of the decoration part 832 (refer to FIG. 3A) disposed between the cover part 931 and the bracket 934, the first connector 9331, and the support member 9334.

In an embodiment, the bracket 934 may serve to protect the cover part 931 and the first connector 9331. For example, the bracket 934 may be disposed to cover one surface of the cover part 931 and the first connector 9331 to thereby protect the cover portion 931 and the first connector 9331 from an impact applied to the one surface of the cover portion 931 and the first connector 9331.

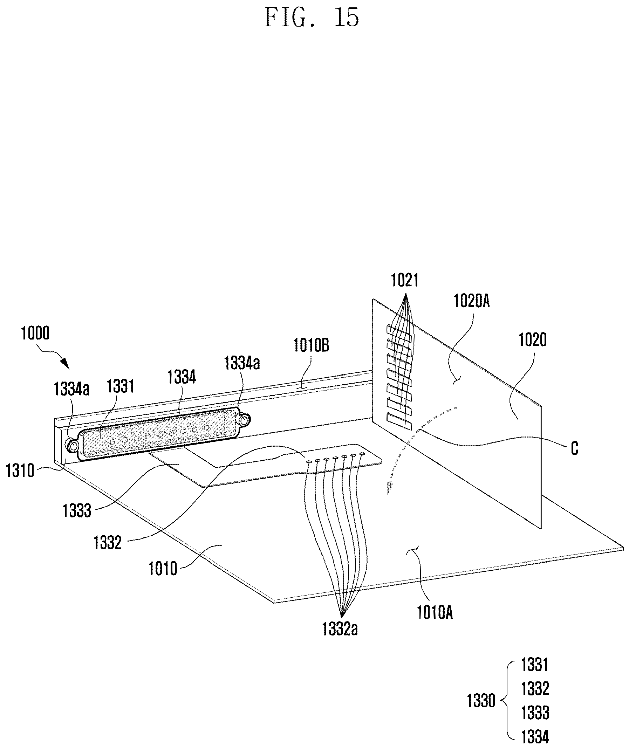

FIG. 15 is a view illustrating an electronic device 1000 including a contact pin 1021 according to an embodiment of the disclosure.

FIG. 15 is a view showing a state before a printed circuit board 1020 including a contact pin 1021 is disposed in the housing 1010.

The electronic device 1000 illustrated in FIG. 15 may refer to the electronic device 200 of FIG. 2A, or may include at least some of the electronic device 200 of FIG. 2A.

The electronic device 1000 according to an embodiment of the disclosure may include a housing 1010, a printed circuit board 1020, and/or a terminal structure 1300.

The shape, function and arrangement of the housing 1010, printed circuit board 1020 and terminal structure 1300 illustrated in FIG. 15 may be substantially the same as the shape, function and arrangement of the housing 810, printed circuit board 820 and terminal structure 830 illustrated in FIGS. 13A and 13B.

In an embodiment, the terminal structure 1300 may include a cover part 1310, a decoration part 832 (refer to FIG. 13A), and a connector part 1330.

In an embodiment, the connector part 1330 may include a first connector 1331, a second connector 1332, a flexible printed circuit board 1333, and/or a support member 1334.

In the terminal structure 1300 illustrated in FIG. 15, the decoration part 832 illustrated in FIG. 13A may be disposed between the cover part 1310 and the first connector 1331 of the connector part 1330.

In an embodiment, the cover part 1310 may be disposed on the second surface 1010B of the housing 1010. Alternatively, the second surface 1010B of the housing 1010 and the cover part 1310 may be formed integrally.

In an embodiment, the flexible printed circuit board 1333 may be electrically connected to the first connector 1331 at one end. The flexible printed circuit board 1333 may be electrically connected to the second connector 1332 at the other end.

In an embodiment, the flexible printed circuit board 1333 may be formed integrally with the second connector 1332. For example, rather than the second connector 1332 being formed separately and connected to the flexible printed circuit board 1333, the second connector 1332 may be included at the end of the flexible printed circuit board 1333.

In an embodiment, the second connector 1332 may include a connector terminal 1332a on one surface. For example, at least one connector terminal 1332a may be arranged on one surface of the second connector 1332.

In an embodiment, a contact pin 1021 may be disposed on the printed circuit board 1020. For example, at least one contact pin 1021 may be arranged on one surface 1020A of the printed circuit board 1020. The contact pin 1021 may be a C-clip type connector.

In an embodiment, the printed circuit board 1020 may be disposed in the housing 1010 along the coupling direction C. For example, one surface 1020A of the printed circuit board 1020 and the first surface 1010A of the housing 1010 may be disposed to be in direct contact with each other.

In an embodiment, when the printed circuit board 1020 is disposed in the housing 1010, the contact pin 1021 of the printed circuit board 1020 may come into contact with the connector terminal 1332a of the second connector 1332. As the contact pin 1021 comes into contact with the connector terminal 1332a, the printed circuit board 1020 and the second connector 1332 may be electrically connected.

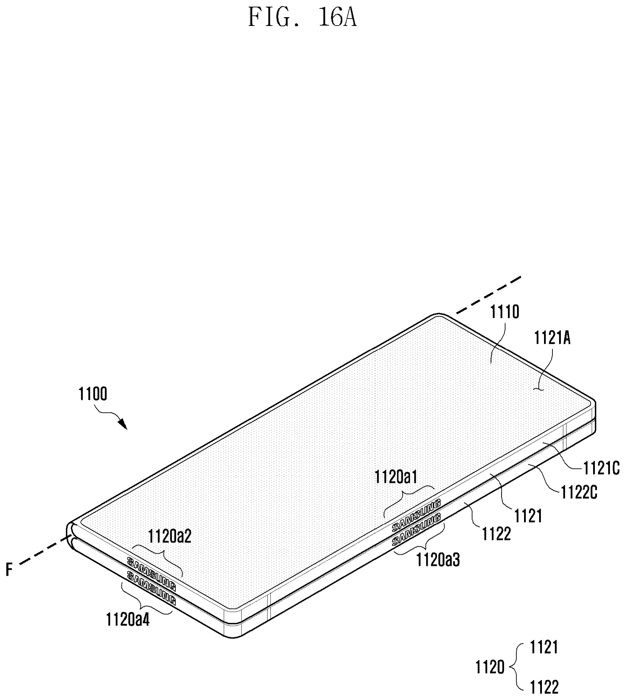

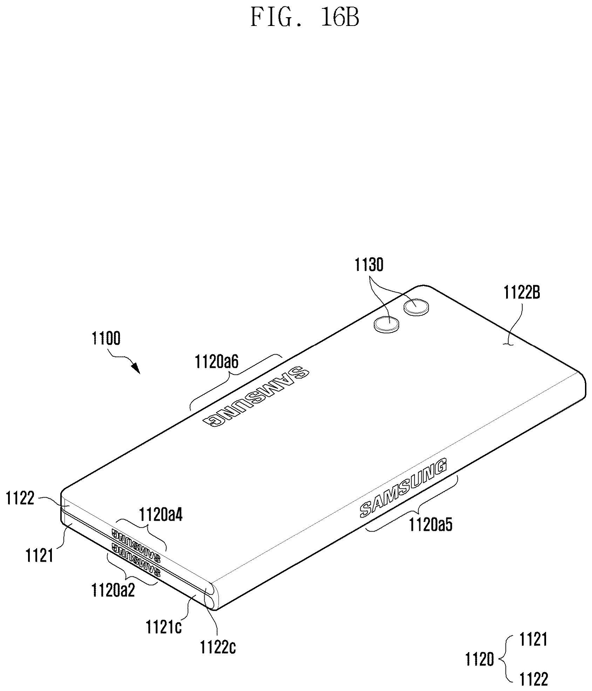

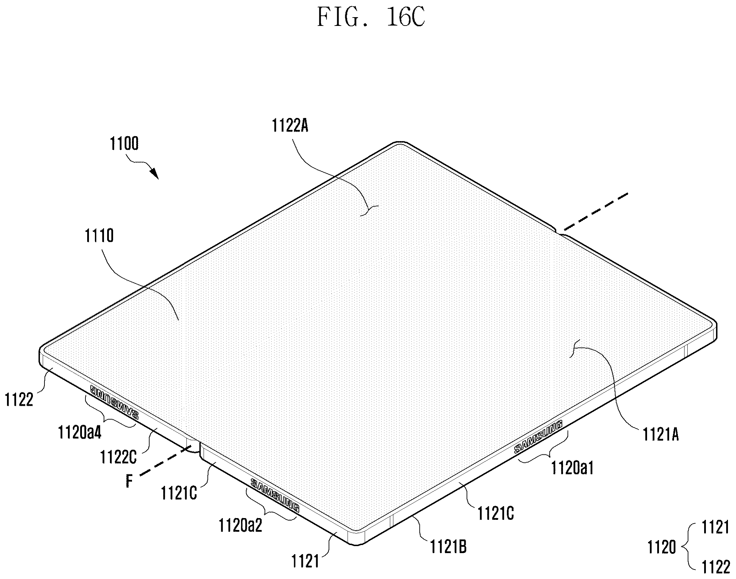

FIGS. 16A, 16B and 16C are views illustrating an electronic device 1100 according to an embodiment of the disclosure.

The electronic device 1100 according to an embodiment of the disclosure may be a foldable-type electronic device. For example, the electronic device 1100 may be an electronic device that can transition from a folded state to an unfolded state, or from an unfolded state to a folded state.

FIG. 16A and FIG. 16B are views illustrating the electronic device 1100 in folded state according to an embodiment. FIG. 16C is a view illustrating the electronic device 1100 in unfolded state.

In an embodiment, the electronic device 1100 may include a display 1110, a housing 1120, and/or a camera 1130.

In an embodiment, the housing 1120 may include a first housing 1121 and/or a second housing 1122.

In an embodiment, the first housing 1121 may include a first surface 1121A, a second surface 1121B, and/or a first side surface 1121C. The first surface 1121A may be an opposite surface of the second surface 1121B. The first side surface 1121C may be a surface that surrounds at least a portion of the space between the first surface 1121A and the second surface 1121B.

In an embodiment, the second housing 1122 may include a third surface 1122A, a fourth surface 1122B, and/or a second side surface 1122C. The third surface 1122A may be an opposite surface of the fourth surface 1122B. The second side surface 1122C may be a surface that surrounds at least a portion of the space between the third surface 1122A and the fourth surface 1122B.

In an embodiment, the display 1110 may be disposed on at least a portion of the first housing 1121 and the second housing 1122. For example, the display 1110 may be disposed on the first surface 1121A of the first housing 1121. The display 1110 may be disposed on the third surface 1122A of the second housing 1122.

In one embodiment, the folded state of the electronic device 1100 may be a state in which the first housing 1121 and the second housing 1122 are arranged to overlap each other. The unfolded state of the electronic device 1100 may be a state in which the first housing 1121 and the second housing 1122 are arranged parallel and substantially on the same plane.

In an embodiment, the first housing 1121 and the second housing 1122 may be rotatably coupled with respect to the folding axis F. For example, the first housing 1121 and the second housing 1122 may be rotated around the folding axis F to transition from the state shown in FIG. 16A (e.g., folded state of the electronic device 1100) to the state shown in FIG. 16C (e.g., unfolded state of the electronic device 1100). The first housing 1121 and the second housing 1122 may be rotated around the folding axis F to transition from the state shown in FIG. 16C (e.g., unfolded state of the electronic device 1100) to the state shown in FIG. 16A (e.g., folded state of the electronic device 1100).

In an embodiment, the housing 1120 may include at least one housing opening (e.g., 1120a1).

In an embodiment, the housing opening (e.g., 1120a1) may be formed on a surface of the housing 1120 on which the display 1110 is not disposed. For example, the first housing opening 1120a1 and the second housing opening 1120a2 may be disposed on the first side surface 1121C of the first housing 1121. The third housing opening 1120a3 and the fourth housing opening 1120a4 may be disposed on the second side surface 1122C of the second housing 1122. The fifth housing opening 1120a5 may be disposed on the first side surface 1121C and/or the second side surface 1122C. The sixth housing opening 1120a6 may be positioned on the fourth surface 1122B of the second housing 1122.

In an embodiment, the first side surface 1121C and the second side surface 1122C may be connected at at least a portion. For example, with reference to FIG. 16B, the first side surface 1121C and the second side surface 1122C may be formed to be connected at a portion, and the fifth housing opening 1120a5 may be formed in the portion where the first side surface 1121C and the second side surface 1122C are connected.

In FIGS. 16A, 16B and 16C, each housing opening (e.g., 1120a1) is depicted as being located at the center of the corresponding surface (e.g., 1121C), but this is an example for illustration, and the location of each housing opening (e.g., 1120a1) may be not limited thereto. For example, each housing opening (e.g., 1120a1) may be located at the end portion of the surface on which it is disposed.

In an embodiment, the housing opening (e.g., 1120a1) may be a region where at least a portion of the terminal structure 300 (refer to FIG. 3A) is exposed to the outside. For example, the conductive region 321 of the terminal structure 300 (refer to FIG. 3A) may penetrate a housing opening (e.g., 1120a1) and be exposed to the outside of the electronic device 1100.

In an embodiment, the camera 1130 may be disposed on the opposite surface of the surface on which the display 1110 is disposed. For example, the camera 1130 may be disposed on the fourth surface 1122B of the second housing 1122.

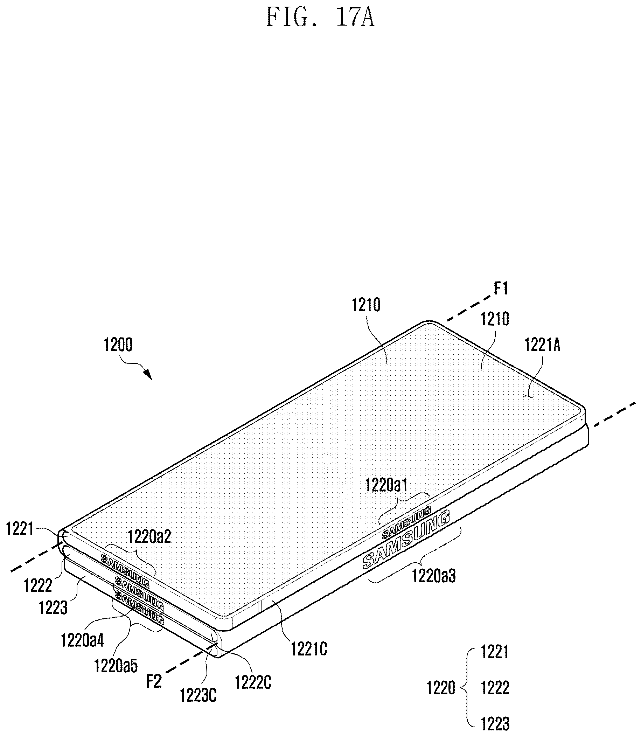

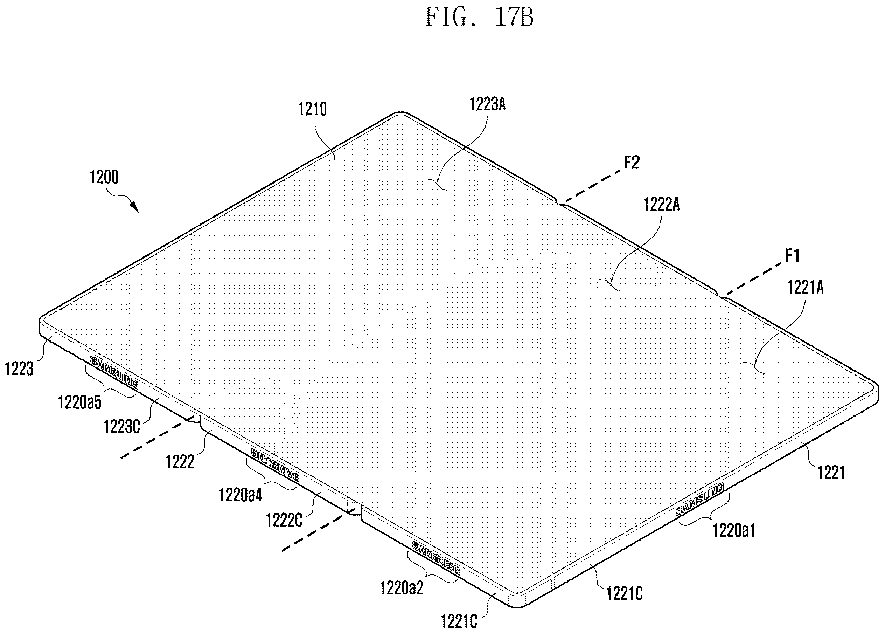

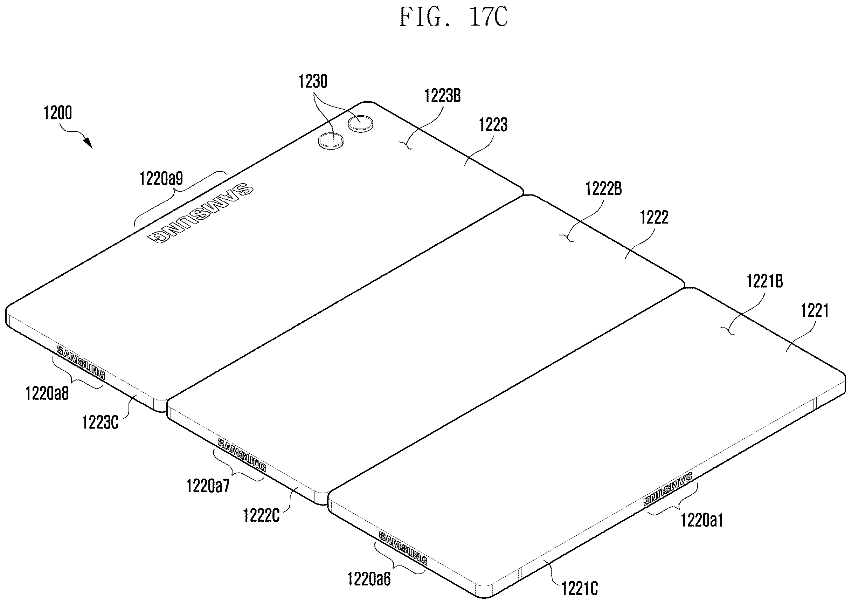

FIGS. 17A, 17B and 17C are views illustrating an electronic device 1200 according to an embodiment of the disclosure.

The electronic device 1200 according to an embodiment of the disclosure may be a foldable-type electronic device. For example, the electronic device 1200 may be an electronic device that can transition from the folded state to the unfolded state, or from the unfolded state to the folded state.

FIG. 17A is a view illustrating the electronic device 1200 in folded state according to an embodiment. FIGS. 17B and 17C are views illustrating the electronic device 1200 in unfolded state.

In an embodiment, the electronic device 1200 may include a display 1210, a housing 1220, and/or a camera 1230.

In an embodiment, the housing 1220 may include a first housing 1221, a second housing 1222, and/or a third housing 1223.

In an embodiment, the folded state of the electronic device 1200 may be a state in which the first housing 1221, the second housing 1222, and the third housing 1223 are arranged to overlap each other. The unfolded state of the electronic device 1200 may be a state in which the first housing 1221, the second housing 1222, and the third housing 1223 are arranged parallel and substantially on the same plane.

In the folded state of the electronic device 1200 illustrated in FIG. 17A, the arrangement of the first housing 1221, the second housing 1222, and the third housing 1223 is exemplary, and the arrangement of the housing 1220 may be not limited thereto. For example, in the folded state of the electronic device 1200, the second housing 1222, the third housing 1223, and the first housing 1221 may be arranged to be stacked in that order.

In an embodiment, the first housing 1221 may include a first surface 1221A, a second surface 1221B, and/or a first side surface 1221C. The first surface 1221A may be an opposite surface of the second surface 1221B. The first side surface 1221C may be a surface that surrounds at least a portion of the space between the first surface 1221A and the second surface 1221B.

In an embodiment, the second housing 1222 may include a third surface 1222A, a fourth surface 1222B, and/or a second side surface 1222C. The third surface 1222A may be an opposite surface of the fourth surface 1222B. The second side surface 1222C may be a surface that surrounds at least a portion of the space between the third surface 1222A and the fourth surface 1222B.

In an embodiment, the third housing 1223 may include a fifth surface **1123A,** a sixth surface **1123B,** and/or a third side surface **1123C.** The fifth surface **1123A** may be an opposite surface of the sixth surface **1123B.** The third side surface **1123C** may be a surface that surrounds at least a portion of the space between the fifth surface **1123A** and the sixth surface **1123B.**

In an embodiment, the display 1210 may be disposed on at least a portion of the first housing 1221, the second housing 1222, and the third housing 1223. For example, the display 1210 may be disposed on the first surface 1221A of the first housing 1221, the third surface 1222A of the second housing 1222, and the fifth surface 1223A of the third housing 1223.

In an embodiment, the first housing 1221 and the second housing 1222 may be rotatably coupled with respect to the first folding axis F1. For example, the first housing 1221 and the second housing 1222 may be rotated about the first folding axis F1 to transition from the state illustrated in FIG. 17A (e.g., folded state of the electronic device 1200) to the state illustrated in FIG. 17B (e.g., unfolded state of the electronic device 1200). The first housing 1221 and the second housing 1222 may be rotated around the first folding axis F1 to transition from the state illustrated in FIG. 17B (e.g., unfolded state of the electronic device 1200) to the state illustrated in FIG. 17A (e.g., folded state of the electronic device 1200).

In an embodiment, the second housing 1222 and the third housing 1223 may be rotatably coupled with respect to the second folding axis F2. For example, the second housing 1222 and the third housing 1223 may be rotated about the second folding axis F2 to transition from the state illustrated in FIG. 17A (e.g., folded state of the electronic device 1200) to the state illustrated in FIG. 17B (e.g., unfolded state of the electronic device 1200). The second housing 1222 and the third housing 1223 may be rotated around the second folding axis F2 to transition from the state illustrated in FIG. 17B (e.g., unfolded state of the electronic device 1200) to the state illustrated in FIG. 17A (e.g., folded state of the electronic device 1200).

In an embodiment, the housing 1220 may include at least one housing opening (e.g., 1220a1).

In an embodiment, the housing opening 1220a1 may be formed on a surface of the housing 1220 of the electronic device 1200 where the display 1210 is not disposed. For example, the first housing opening 1220a1, the second housing opening 1220a2, and the sixth housing opening 1220a6 may be disposed on the first side surface 1221C of the first housing 1221. The third housing opening 1220a3 may be disposed on the second side surface 1222C and/or the third side surface 1223C. The fourth housing opening 1220a4 and the seventh housing opening 1220a7 may be disposed on the second side surface 1222C of the second housing 1222. The fifth housing opening 1220a5 and the eighth housing opening 1220a8 may be disposed on the third side surface 1223C of the third housing 1223.

With reference to FIGS. 17B and 17C, the sixth housing opening 1220a6 may be located in an opposite direction to the second housing opening 1220a2. The seventh housing opening 1220a7 may be located in an opposite direction to the fourth housing opening 1220a4. The eighth housing opening 1220a8 may be located in an opposite direction to the fifth housing opening 1220a5.

In an embodiment, the second side surface 1222C and the third side surface 1223C may be connected at at least a portion. For example, with reference to FIG. 17A, the second side surface 1222C and the third side surface 1223C may be formed to be connected at a portion, and the third housing opening **1120a3** may be formed in the portion where the second side surface 1222C and the third side surface 1223C are connected.

In FIGS. 17A, 17B and 17C, each housing opening (e.g., 1220a1) is depicted as being located at the center of the corresponding surface (e.g., 1221C), but this is an example for illustration, and the location of each housing opening (e.g., 1220a1) may be not limited thereto. For example, each housing opening (e.g., 1220a1) may be located at the end portion of the surface on which it is disposed.

In an embodiment, the housing opening (e.g., 1220a1) may be a region where at least a portion of the terminal structure 300 (refer to FIG. 3A) is exposed to the outside. For example, the conductive region 321 of the terminal structure 300 (refer to FIG. 3A) may penetrate a housing opening (e.g., 1220a1) and be exposed to the outside of the electronic device 1200.

In an embodiment, the camera 1230 may be disposed on the opposite surface of the surface on which the display 1210 is disposed. For example, the camera 1230 may be disposed on the sixth surface 1223B of the third housing 1223.

An electronic device 200 according to an embodiment of the disclosure may include a printed circuit board 820, a housing 210, and a terminal structure 300.

In an embodiment, the printed circuit board 820 may be disposed inside the housing 210.

In an embodiment, the terminal structure 300 may be disposed at least partially in a region of the housing 210.

The terminal structure 300 according to an embodiment of the disclosure may include a connector part 330, a decoration part 320, and a cover part 310.

In an embodiment, the connector part 330 may include a first connector 331 in which a connector terminal 3311 is disposed and a second connector 332 electrically connected to the printed circuit board 820.

In an embodiment, the decoration part 320 may include a conductive region 321 that is in contact with the connector terminal 3311 at one end and is exposed to the outside of the housing 210 at the other end, and a non-conductive region 322 surrounding the conductive region 321, and may be disposed on the first connector 331.

In an embodiment, the cover part 310 may include a cover opening 311 in which at least a portion of the conductive region 321 is disposed, and may be disposed between the decoration part 320 and the housing 210.

In an embodiment, the terminal structure 300 may further include an adhesive part 340 that is disposed between the cover part 310 and the decoration part 320 to couple the cover part 310 and the decoration part 320.

In an embodiment, the decoration part 320 may include a plurality of conductive regions 321 and may further include an insulating member 723 disposed between the plural conductive regions 321.

In an embodiment, the conductive region 321 may include a protrusion 3211 that extends in a direction from one surface of the non-conductive region 322 toward the first connector 331 and comes into contact with the connector terminal 3311.

In an embodiment, the connector part 330 may further include a support member 334 that has one surface on which the first connector 331 is disposed and supports the first connector 331, and the support member 334 may include support member openings 3341 respectively at one end and the other end.

In an embodiment, the cover part 310 may further include coupling regions 312 formed in one direction and the other direction of the cover opening 311, and the terminal structure 300 may further include a coupling member 350 that is inserted into the support member opening 3341 of the support member 334 and the coupling region 312 of the cover part 310 to couple the connector part 330 and the cover part 310.

In an embodiment, the connector part 430 may further include a first flexible printed circuit board 433 that is electrically connected to the first connector 431 at one end and electrically connected to the second connector 432 at the other end.

In an embodiment, the connector part 430 may further include a third connector 436 connected to the printed circuit board 820, and a second flexible printed circuit board 435 that is electrically connected to the third connector 436 at one end and connected to the second connector 432 at the other end.

In an embodiment, the connector part 530 may further include a third connector 536 connected to the printed circuit board 820, and a second flexible printed circuit board 533 that is electrically connected to the third connector 536 at one end and connected to the first connector 531 at the other end.

In an embodiment, the terminal structure 930 may further include a bracket 934 disposed to cover the cover part 931 and the first connector 9331, and an adhesive member 935 that couples the bracket 934 to the cover part 931.

In an embodiment, the cover opening 311 may be formed in the same shape as the perimeter of the conductive region 321 appearing on one side of the non-conductive region 322.

In an embodiment, the housing 1120 may include a first housing 1121 and a second housing 1122 rotatably connected to the first housing 1121 with respect to a folding axis F, and the electronic device 1100 may be a foldable-type device.

In an embodiment, the cover part 310 may be formed integrally with the housing 210.

In an embodiment, **the electronic device 200** may further include a display 220 disposed on one surface 210A of the housing 210, and the terminal structure 300 may be disposed on the other surface 210B being the opposite to the one surface 210A of the housing 210 such that at least a portion of the terminal structure is exposed to the outside.

In an embodiment, the conductive region 321 may include an elastic material.

A terminal structure 300 according to an embodiment of the disclosure may include: a connector part 330 including a first connector 331 in which a connector terminal 3311 is disposed; a decoration part 320 that includes a conductive region 321 that contacts the connector terminal 3311 at one end and is exposed to the outside of the terminal structure 300 at the other end, and a non-conductive region 322 surrounding the conductive region 321, and is disposed in the first connector 331; and a cover part 310 that includes a cover opening 311 in which at least a portion of the conductive region 321 is disposed and is disposed in the decoration part 320.

The electronic device according to an embodiment of the disclosure may be one of various types of devices. The electronic device may include, for example, a portable communication device (e.g., smartphone), a computer device, a portable multimedia device, a portable medical instrument, a camera, a wearable device, or a home appliance. The electronic device according to an embodiment of the disclosure is not limited to those described above.

An embodiment of the disclosure and terms used therein are not intended to limit the technical features described in the disclosure to specific embodiments, and should be understood as including various modifications, equivalents, or substitutes of a corresponding embodiment. With regard to the description of the drawings, similar reference numerals may be used to refer to similar or related elements. A singular form of a noun corresponding to a specific item may include one or multiple instances of the item unless the relevant context clearly indicates otherwise. In the disclosure, each of phrases such as "A or B", "at least one of A and B", "at least one of A or B", "A, B or C", "at least one of A, B and C", and "at least one of A, B or C" may include any one of or all possible combinations of the items enumerated together in the corresponding one of the phrases. Terms such as "1st" and "2nd", or "first" and "second" may be used to simply distinguish a corresponding component from another, and does not limit the components in other aspect (e.g., importance or order). When an element (e.g., first element) is referred to, with or without the term "operably" or "communicatively", as "coupled to/with" or "connected to/with" another element (e.g., second element), this means that the element may be connected or coupled to the other element directly (e.g., wiredly), wirelessly, or via a third element.

The term "module" used in an embodiment of the disclosure may include a unit implemented in hardware, software, or firmware, and may be used interchangeably with other terms, for example, "logic", "logic block", "component", or "circuit". A module may be a single integral component, or a minimum unit or part thereof performing one or more functions. For example, according to an embodiment, a module may be implemented in a form of an application-specific integrated circuit (ASIC).

An embodiment of the disclosure may be implemented as software (e.g., programs 140) including one or more instructions that are stored in a storage medium (e.g., internal memory 136 or external memory 138) readable by a machine (e.g., electronic device 101). For example, a processor (e.g., processor 120) of the machine (e.g., electronic device 101) may invoke at least one of the one or more instructions stored in the storage medium to execute it. This allows the machine to be operated to perform at least one function according to the invoked at least one instruction. The one or more instructions may include a code generated by a complier or a code executable by an interpreter. The machine-readable storage medium may be provided in the form of a non-transitory storage medium. Here, the term "non-transitory" simply means that the storage medium is a tangible device and does not include a signal (e.g., electromagnetic wave), but this term does not distinguish whether data is stored semi-permanently or temporarily in the storage medium.

According to an embodiment, a method according to various embodiments of the disclosure may be provided by being included in a computer program product. The computer program product may be traded as a commodity between a seller and a purchaser. A computer program product may be distributed in the form of a machine-readable storage medium (e.g., compact disc read only memory (CD-ROM)) or be distributed online (e.g., download or upload) directly between two user devices (e.g., smartphones) through an application store (e.g., PlayStore^{™}). For on-line distribution, at least a portion of the computer program product may be temporarily stored or temporarily created in a machine readable storage medium such as a memory of a manufacturer's server, an application store's server, or a relay server.

According to an embodiment, each component (e.g., module or program) of the above-described components may include a single entity or multiple entities, and some of the multiple entities may be separately arranged on other components. According to various embodiments, one or more components or operations may be omitted from the above-described components, or one or more other components or operations may be added. Alternatively or additionally, a plurality of components (e.g., modules or programs) may be integrated into a single component. In this case, the integrated component may perform one or more functions of each of the plurality of components in the same or similar manner as they are performed by a corresponding one of the plurality of components before the integration.

According to an embodiment, operations performed by a module, a program, or another component may be carried out in sequence, in parallel, by repetition, or heuristically, or one or more of the operations may be executed in a different order or may be omitted, and one or more other operations may be added.

## Claims

1. An electronic device (200) comprising:
a printed circuit board (820);
a housing (210) inside which the printed circuit board is disposed; and
a terminal structure (300) disposed at least partially in a region of the housing,
wherein the terminal structure includes:
a connector part (330) that includes a first connector (331) in which a connector terminal (3311) is disposed and a second connector (332) electrically connected to the printed circuit board;
a decoration part (320) that includes a conductive region (321) in contact with the connector terminal at one end and exposed to an outside of the housing at the other end, and a non-conductive region (322) surrounding the conductive region, and is disposed on the first connector; and
a cover part (310) that includes a cover opening (311) in which at least a portion of the conductive region is disposed and is disposed between the decoration part and the housing.

2. The electronic device of claim 1, wherein the terminal structure further includes an adhesive part (340) that is disposed between the cover part and the decoration part to couple the cover part and the decoration part.

3. The electronic device of claim 1, wherein the decoration part includes a plurality of conductive regions, and further includes an insulating member (723) disposed between the plural conductive regions.

4. The electronic device of claim 1, wherein the conductive region includes a protrusion (3211) that extends in a direction from one surface of the non-conductive region toward the first connector and comes into contact with the connector terminal.

5. The electronic device of claim 1, wherein:
the connector part further includes a support member (334) that has one surface on which the first connector is disposed and supports the first connector; and
the support member includes support member openings (3341) respectively at one end and the other end.

6. The electronic device of claim 5, wherein:
the cover part further includes coupling regions (312) formed in one direction and the other direction of the cover opening; and
the terminal structure further includes a coupling member (350) that is inserted into the support member opening of the support member and the coupling region of the cover part to couple the connector part and the cover part.

7. The electronic device of claim 1, wherein the connector part further includes a first flexible printed circuit board (433) that is electrically connected to the first connector at one end and electrically connected to the second connector at the other end.

8. The electronic device of claim 7, wherein the connector part further includes a third connector (436) connected to the printed circuit board, and a second flexible printed circuit board (435) that is electrically connected to the third connector at one end and connected to the second connector at the other end.

9. The electronic device of claim 7, wherein the connector part further includes a third connector (536) connected to the printed circuit board, and a second flexible printed circuit board (533) that is electrically connected to the third connector at one end and connected to the first connector at the other end.

10. The electronic device of claim 1, wherein the terminal structure further includes a bracket (934) disposed to cover the cover part and the first connector, and an adhesive member (935) that couples the bracket to the cover part.

11. The electronic device of claim 1, wherein the cover opening is formed in a shape identical to a perimeter of the conductive region appearing on one side of the non-conductive region.

12. The electronic device of claim 1, wherein:
the housing includes a first housing (1121) and a second housing (1122) rotatably connected to the first housing with respect to a folding axis (F); and
the electronic device is a foldable-type device.

13. The electronic device of claim 1, wherein the cover part is formed integrally with the housing.

14. The electronic device of claim 1, further comprising a display (220) disposed on one surface of the housing, and wherein the terminal structure is disposed on the other surface being the opposite to the one surface of the housing in a manner that at least a portion thereof is exposed to the outside.

15. The electronic device of claim 1, wherein the conductive region includes an elastic material.
